(19) Europäisches Patentamt
European Patent Office
Office européen des brevets

(11) Publication number: **0 194 318**
**A1**

(12) # EUROPEAN PATENT APPLICATION

published in accordance with Art. 158(3) EPC

(21) Application number: 85904294.7

(51) Int. Cl.[4]: H 03 H 17/04

(22) Date of filing: 02.09.85

Data of the international application taken as a basis:

(86) International application number:
PCT/JP85/00489

(87) International publication number:
WO86/01656 (13.03.86 86/06)

(30) Priority: 04.09.84 JP 183766/84
04.09.84 JP 183767/84
04.09.84 JP 183769/84

(43) Date of publication of application:
17.09.86 Bulletin 86/38

(84) Designated Contracting States:
BE DE GB IT NL

(71) Applicant: Oki Electric Industry Company, Limited
7-12, Toranomon 1-chome Minato-ku
Tokyo 105(JP)

(72) Inventor: KOBAYASHI, Masaki Oki Electric Industry Co., Ltd.
7-12, Toranomon 1-chome
Minato-ku Tokyo 105(JP)

(72) Inventor: ITOH, Yoshio Oki Electric Industry Co., Ltd.
7-12, Toranomon 1-chome
Minato-ku Tokyo 105(JP)

(72) Inventor: TAKUMI, Ichi Oki Electric Industry Co., Ltd.
7-12, Toranomon 1-chome
Minato-ku Tokyo 105(JP)

(72) Inventor: HAYAHARA, Etsuro
1602-46, Kamiyacho
Kasugai-shi Aichi 480-03(JP)

(74) Representative: Boydell, John Christopher et al,
Stevens, Hewlett & Perkins 5 Quality Court Chancery Lane
London, WC2A 1HZ(GB)

(54) **METHOD OF CONSTITUTING A DIGITAL FILTER.**

(57) A method of constituting a digital filter which does not form in the circuit a loop that excludes delay elements, which has a low coefficient of sensitivity and a low sensitivity for the internal operation word length. First, a node or closed circuit equation of an analog filter which is to be converted into a digital filter, is subjected to S-Z conversion to convert it into an equation which is mapped on a Z-plane. The digital filter to be found is constituted by using the equation mapped on the Z-plane as an equation which has a delay to give a node voltage or a closed circuit current. The digital filter can also be found by converting the inductance of the analog filter into an equivalent circuit which consists of a resistance and a capacitance having positive and negative values, and by using the node or closed circuit equation of this equivalent circuit.

EP 0 194 318 A1

./...

*Fig. 8*

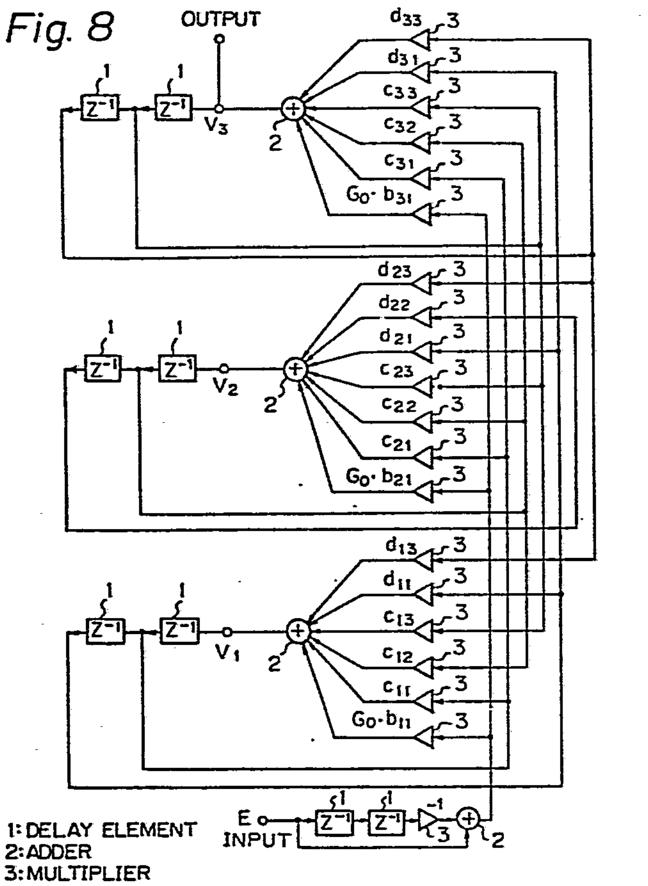
OUTPUT
$V_3$
$V_2$
$V_1$
$d_{33}$
$d_{31}$
$c_{33}$
$c_{32}$
$c_{31}$
$G_0 \cdot b_{31}$
$d_{23}$
$d_{22}$
$d_{21}$
$c_{23}$
$c_{22}$
$c_{21}$
$G_0 \cdot b_{21}$
$d_{13}$
$d_{11}$
$c_{13}$
$c_{12}$
$c_{11}$
$G_0 \cdot b_{11}$
E
INPUT
1: DELAY ELEMENT
2: ADDER
3: MULTIPLIER

DESCRIPTION

The present invention relates to a digital filter having reduced coefficient sensitivity and reduced sensitivity to internal operation word length.

With the rapid progress of recent IC technologies, various commuinication equipments have been digitized relatively with ease to enable enormous and versatile information processing to be effected. Especially, digital filters have gradually taken the place of analog filters with very frequent use in digital signal processing.

A digital filter comprises in general three types of basic elements (address, multipliers, and delay elements) which are defined by a difference equation. This difference equation is derived with proper transformation of variables of an LCR analog filter as shown in "Digital Filters : Analysis and Design" by A. Antoniou, McGraw Hill, Inc. 1979.

The digital filter so obtained frequently causes a delay-free loop (hereinafter abbreviated as DFL) and thus impossible to act as a filter. In addition, the digital filter, owing to its high sensitivity to a filter coefficient and an internal operation word length, is increased in the coefficient word length and the internal operation word length.

In view of the drawbacks with the conventional filter, it is an object of the present invention to provide a digital filter without DFL.

To achieve the above object, a digital filter according to the present invention having adder means, multiplier means, and delay means in combination includes a means for estimation a node equation or a closed circuit equation to transform an analog filter to the digital filter, a means for subjecting these equations to S-Z transformation to map them on a Z-plane, and a means for transforming the equations mapped on the Z-plane to equations each having mode voltage or closed circuit currents and having any delay, the equation so having any delay and presenting the mode voltage providing the combination of the adder means, multiplier means, and delay means.

The digital filter according to the present invention may also take the another type of digital filtèr which, after transforming inductance of the analog filter described above to an equivalent circuit comprising resistors and capacitors both having positive and negative values, estimates a node equation or a closed circuit equation of the equivalent circiut.

The above and other objects, features and advantages of the present invention will become more apparent from the following description when taken in conjunction with the accompanying drawings in which a preferred embodiment of the present invention is shown by way of illustrative example.

Fig. 1 is a view illustrating arrangement of an LC analog filer,

Fig. 2 is a view for realizing node voltagae $V_k$,

Fig. 3 is a circuit diagram of a first embodiment of a digital filter according to the present invention,

Fig. 4 is a circuit diagram of a fifth polarized low-pass filter,

Fig. 5 is a view illustrating a frequency conversion characteristic by bilinear s - z transformation,

Fig. 6 is a circuit diagram with a cut-off frequency of the filter of fig. 5 subjected to correction,

Fig. 7 is tables showing coefficients of an equation (13) described later,

Fig. 8 is a circuit diagram of a digital filter constructed on the basis of the first embodiment according to the present invention with respect to the filter of Fig. 4,

Fig. 9 is a review illustrating an amplitude characteristic of the filter of Fig. 4,

Fig. 10 is a view illustrating an amplitude characteristic of the filter of Fig. 8,

Fig. 11 is a view illustrating amplitude characteristics for respective coefficient word lengths of the filter of Fig. 8,

Fig. 12 is a circuit diagram of a prior secondary cascade digital filter,

Fig. 13 is a view showing amplitude characteristics of the filter of Fig. 12 for coefficient word lengths thereof,

Fig. 14 is a table showing relative errors of gains of the filters respectively shown in Figs. 8 and 12 with respect to internal operation word lengths thereof,

Fig. 15 is a view showing arrangement of an LC analog filter,

Fig. 16 is a circuit diagram embodying a closed circuit current $I_k$,

Fig. 17 is a circuit diagram of a second embodiment of a digital filter according to the present invention,

Fig. 18 is a circuit diagram of a fifth polarized low-pass filter ,

Fig. 19 is a view illustrating a frequency transformation characteristic by the bilinear s - z transformation,

Fig. 20 is a circuit diagram corrected in a cut-off frequency of the filter of Fig. 18,

Fig. 21 is a table showing coefficients of an equation (33),

Fig. 22 is a circuit diagram of the digital filter constructed on the basis of the second embodiment of the present invention,

Fig. 23 is a view illustrating an amplitude characteristic of the filter shown in Fig. 18,

Fig. 24 is a view illustrating an amplitude characteristic of the filter shown in Fig. 24,

Fig. 25 is a view illustrating amplitude characteristics of the filter of Fig. 22 for respective coefficient word length thereof,

Fig. 26 is a circuit diagram of a prior secondary cascade digital filter,

Fig. 27 is a view illustrating amplitude characteristics of the filter of Fig. 26 for respective coefficient word lengths thereof,

Fig. 28 is a table showing relative errors of gains of the filters of Figs. 22 and 26 for respective internal operation record lengths thereof,

Fig. 29 is a circuit diagram illustrating equivalent transformation of inductance L,

Fig. 30 is a circuit diagram of a third embodiment of the digital filter according to the present invention,

Fig. 31 is a fifth polarized low-pass filter,

Fig. 32 is a view showing a frequency transformation characteristic by bilinear transformation,

Fig. 33 is an equivalent diagram of the fifth polarized low-pass filter,

Fig. 34 is a fifth polarized low-pass digital filter constructed based on the third embodiment of the present invention,

Fig. 35 is a view illustrating a theoretical logarithmic amplitude of the fifth polarized low-pass digital filter,

Fig. 36 is a view illustrating an experimental logarithmic amplitude characteristic when the filter coefficient of the fifth polarized low-pass digital filter is 23 bits,

Fig. 37 is a view illustrating characteristics for respective coefficient word lenghts,

Fig. 38 shows a fifth low-pass digital filter by a prior secondary cascading method,

Fig. 39 is a view illustrating characteristics of the filter of Fig. 38 for respective coefficient word lengths, and

Fig. 40 is a view illustrating relative errors by the filters of the third embodiment of the present invention and by the secondary cascade method.

A first embodiment of a digital filter according to the present invention will be described with reference to the accompanying drawings.

Referring to Fig. 1 illustrating arrangement of an LC analog filter, a node equation of the filter is expressed in general by the following equation (1).

$$\begin{pmatrix} G_0E \\ 0 \\ \vdots \\ 0 \end{pmatrix} = \begin{pmatrix} y_{11} \cdots y_{1n} \\ y_{21} \cdots y_{2n} \\ \cdots\cdots \\ y_{n1} \cdots y_{nn} \end{pmatrix} \begin{pmatrix} V_1 \\ V_2 \\ \vdots \\ V_n \end{pmatrix} \quad (1)$$

Here, $y_{ij}$ is given by the following equation (2) in

terms of conductance $G_{ij}$, capacitance $C_{ij}$, and inductance $L_{ij}$.

$$y_{ij} = G_{ij} + sC_{ij} + \frac{1}{sL_{ij}} \qquad (2)$$

In the figure, designated at E is electromotive force, $R_O$ is equal to $1/G_O$, $R_L$ is terminal resistance, and $V_i$ (i = 1, 2, ..., n)is node voltage.

The equation (1) can be given by the following equation (3) by use of the equation (2).

$$E = \left[ G_{ij} + sC_{ij} + \frac{1}{sL_{ij}} \right] V \qquad (3)$$

where

$$E = \begin{pmatrix} G_0E \\ 0 \\ \vdots \\ 0 \end{pmatrix} \qquad V = \begin{pmatrix} V_1 \\ V_2 \\ \vdots \\ V_n \end{pmatrix}$$

Then, let us execute the following bilinear s - z transformation

$$s = \frac{2}{T} \frac{1 - z^{-1}}{1 + z^{-1}} \qquad (4)$$

for the equation (3), where s is a complex variable of a transfer function $H_A(s)$ of an analog filter, z is an complex variable of a transfer function $H_D(z)$ of a digital filter, and T indicates a sampling interval.

Substituting the equation (4) for the equation (3) and putting it in order,

$$(1 - z^{-2})E = \left[ (G_{ij} + C_{ij}\frac{2}{T} + \frac{1}{L_{ij}}\frac{T}{2}) + (\frac{1}{L_{ij}}\frac{T}{2} - C_{ij}\frac{2}{T}) 2z^{-1} + (\frac{1}{L_{ij}}\frac{T}{2} + C_{ij}\frac{2}{T} - G_{ij}) z^{-2} \right] V \qquad (5)$$

is obtained.

Assuming here $(A) = \left[ G_{ij} + C_{ij}\frac{2}{T} + \frac{1}{L_{ij}}\frac{T}{2} \right]$, and multiplying both sides of the equation, (5) by the inverse matrix $(A)^{-1}$ of (A),

$$(1 - z^{-2}) \cdot (A)^{-1} \cdot E = V + 2z^{-1} \cdot (A)^{-1} \left[ \frac{1}{L_{ij}}\frac{1}{2} - C_{ij}\frac{2}{T} \right] \cdot V + z^{-2} \cdot (A)^{-1} \left[ \frac{1}{L_{ij}}\frac{T}{2} + C_{ij}\frac{2}{T} - G_{ij} \right] \cdot V \qquad (6)$$

is obtained.

Furtheremore, putting (6) in order and transforming it to a form to derive node voltage V,

$$V = (1 - z^{-2}) \cdot (B) \cdot E + z^{-1} \cdot (C) \cdot V + z^{-2} \cdot (D) \cdot V \qquad (7)$$

$$(B) = (A)^{-1}, \qquad (C) = -2(A)^{-1} \left[ \frac{1}{L_{ij}}\frac{T}{2} - C_{ij}\frac{2}{T} \right],$$

$$(D) = -(A)^{-1} \cdot \left( \frac{1}{L_{ij}}\frac{T}{2} + C_{ij}\frac{2}{T} - G_{ij} \right)$$

(i,j) elements of the matrices (B),(C), and (D) are assumed respectively to be $b_{ij}$, $c_{ij}$, and $d_{ij}$.

n equations are involved in the equation (7), and the k-th equation thereamong is expressible as

$$V_k(z) = b_{k1}G_0E(z)\cdot(1 - z^{-2}) + \sum_{j=1}^{n} C_{kj}V_j(z)\cdot z^{-1} + \sum_{j=1}^{n} d_{kj}V_j(z)\cdot z^{-2} \quad (8)$$

A difference equation is obtained from this as

$$\upsilon_k(mT) + b_{k1}G_0\{e(mT) - e((m-2)T)\} + \sum_{j=1}^{n} C_{kj}\,\upsilon_j((m-1)T) + \sum_{j=1}^{n} d_{kj}\,\upsilon_j((m-2)T) \quad (9)$$

where $\upsilon_k(mT)$ and $e(mT)$ are inverse z-transformation of $V_k(z)$ and $E(z)$. The equation (9) is provided to derive $\upsilon_k(mT)$ from $\upsilon_j((m - 1)T$, $\upsilon_j(m - 2)T)(j = 1, 2, \ldots, n)$ and $[e(mT) - e((m - 2)T)]$ and can be represented by a circuit composed of the delay element 1, adder means 2, and multiplier means 3 of Fig. 2. Thus, the equation (7) provides n circuits to derive $\upsilon_k(mT)$ for k from 1 to n, and forms the digital filter shown in Fig. 3 with addition of delay elements.

It is obvious from Fig. 3 and the equation (9) that $\upsilon_j$ at the same time, i.e., $\upsilon_j(mT)$ is not needed to provide arbitrary $\upsilon_k(mT)$. Namely, a digital filter can be constructed without causing DFL. In addition, the above construction method can be applied to an analog filter employing a circuit element having a dimension of the square of s or more which can be transformed to an LCR filter by use of impedance scaling.

Moreover, a digital filter without DFL can be assured in the same manner even with use of another known s - z

transformation, e.g.,

$$s = z^1/(1+z^{-1}),\quad s = 1-z^{-1},\quad s = (z^2-\alpha z+1)/(z^2-1)$$

instead of the s - z transformation of the expression (4).

Let us then describe an example wherein a fifth polarized low-pass filter shown in Fig. 4 is transformed to a digital filter, based on the procedure given in the first embodiment of the present invention.

An analog transfer function $H_A(s)$ of the fifth polarized low-pass filter of Fig. 4 (cut-off frequency: $1MH_z$, allowable ripple contents of the pass band: 0.28dB, attenuation pole frequencies: $1.369345MH_z$ and $1.988127MH_z$) is given as

$$H_A(s) = \frac{1}{2}\,\frac{A_4s^4 + A_2s^2 + 1}{B_5s^5 + B_4s^4 + B_3s^3 + B_2s^2 + B_1s + 1} \qquad (10)$$

where

$A_2 = 0.01991716490$

$A_4 = 8.656982093 \times 10^{-5}$

$B_1 = 0.4692808372$

$B_2 = 0.1158863247$

$B_3 = 0.02345920748$

$B_4 = 2.200704185 \times 10^{-3}$

$B_5 = 2.594782157 \times 10^{-4}$

Effecting the bilinear s - z transformation shown in the equation (4) for the analog transfer function $H_A(s)$, frequency distortion is caused between the analog frequency and the digital frequency. A relation

$$\frac{\omega_A T}{2} = \tan \frac{\omega_D T}{2} \qquad (11)$$

holds at that time between a circular frequency $\omega_A$ in the analogregion and that $\omega_D$ in the digital region, as shown in Fig. 5.

The frequency axis of the analog filter is previously changed to eliminate the influence of nonlinear distortion on the frequency. Namely, to permit the cut-off frequency of a digital filter designed with use of the equation (11) to get a desired frequency, element parameters of the analog filter are altered to shift the cut-off frequency. In the example described above, assuming a sampling period T = 0.1(μs), the cut-off frequency $f_A$ of the analog filter must satisfy

$$f_A = \frac{1}{\Pi T} \tan(\Pi f_D T) = 1.03425152 (MHz)$$

from the equation (11) to obtain the cut-off frequency $f_D$ = 1$MH_Z$ of the digital filter. For this purpose, capacitance and inductance of the circuit of Fig. 4 must be multiplied by $f_D/f_A$. Fig. 6 shows the circuit so obtained.

The node equation is then given as

$$\begin{pmatrix} G_0E \\ 0 \\ 0 \end{pmatrix} = \begin{pmatrix} G_0 + s(C_1 + C_2) + \frac{1}{sL_1} & -sC_2 - \frac{1}{sL_1} & 0 \\ -sC_2 - \frac{1}{sL_1} & s(C_2 + C_3 + C_4) + \frac{1}{s}(\frac{1}{L_1} + \frac{1}{L_2}) & -sC_4 - \frac{1}{sL_2} \\ 0 & -sC_4 - \frac{1}{sL_2} & G_0 + s(C_4 + C_5) + \frac{1}{sL_2} \end{pmatrix} \cdot \begin{pmatrix} V_1 \\ V_2 \\ V_3 \end{pmatrix} \qquad (12)$$

where $G_0 = 1/R_0$. Effecting the bilinear s - z transformation for the equation (14) and putting them in order with use of the procedure described above,

$$\begin{pmatrix} V_1 \\ V_2 \\ V_3 \end{pmatrix} = \begin{pmatrix} b_{11} \\ b_{21} \\ b_{31} \end{pmatrix} G_0 \cdot E \cdot (1 - z^{-2}) + \begin{pmatrix} C_{11} & C_{12} & C_{13} \\ C_{21} & C_{22} & C_{23} \\ C_{31} & C_{32} & C_{33} \end{pmatrix} \begin{pmatrix} V_1 \\ V_2 \\ V_3 \end{pmatrix} z^{-1} + \begin{pmatrix} d_{11} & d_{12} & d_{13} \\ d_{21} & d_{22} & d_{23} \\ d_{31} & d_{32} & d_{33} \end{pmatrix} \begin{pmatrix} V_1 \\ V_2 \\ V_3 \end{pmatrix} z^{-2} \quad (13)$$

Here, $G_o = 10^{-3}$. Fig. 7 shows values of the coefficients $b_{ij}$, $c_{ij}$, and $d_{ij}$. As shown in Fig. 8, a digital filter is constructed following three difference equations yielded from the equation (13).

Let us compare here a logarithmic amplitude characteristic of the original fifth polarized low-pass filter of Fig. 4 with that of the digital filter of Fig. 8.

a. Logarithmic Amplitude Characteristic of Original Fifth Low-Pass Filter.

Frequency distortion of the transfer function $H_A(s)$ in the s region of the equation (10) produced owing to the vilinear s - z transformation is previously corrected as described before, and then subjected to the bilinear s - z transformation.

After substituting the resultant transfer function $H_D(z)$ in the z region for

$$z = e^{j\Omega} \qquad (14)$$

the logarithmic amplitude characteristic can be obtained with use of $20\log_{10}|H_D(e^{je})|$ (dB). The result is shown in Fig. 9.

b. Logarithmic Amplitude characteristic of Digital Filter Shown in Fig. 8.

A unit sample series is entered into the imput of the digital filter shown in Fig. 8 to provide an impulse response, which is then subjected to fast Fourier transformation whereby the logarithmic amplitude characteristic can be estimated. Fig. 10 shows the logarithmic amplitude characteristic with the filter coefficient of 32 bits. But, a coefficient of the digital filter is represented with use of a binary floating point, and only a fixed point part thereof is rounded to a designated word length. For an internal operation format, a single accuracy real number format of a floating point (exponent: 8 bits fixed point part: 24 bits) is employed.

As shown in Figs. 9 and 10, the amplitude characteristic of the first embodiment of a digital filter according to the present invention is very excellently coincides with that of the original analog filter.

Then, let us describe coefficient sensitivity of the digital filter.

A digital filter shown in fig. 8 is yielded by applying a filter construction method according to the present invention, the fifth polarized low-pass-filter shown in Fig. 4 as described above and changes of the logarithmic amplitude characteristic of the digital filter with respect to word lengths of the multiplication coefficient thereof are shown in Fig. 11. Fig. 12 shows an exemprary digital filter yielded by transforming the fifth polarized low-pass filter described above to a secondary cascade digital filter being a typical of conventional arrangement. The secondary cascade digital filter is constructed based on a transfer function

$$H(z) = A_0 \frac{(1 + A_{(1)}z^{-1} + z^{-2})(1 + A(z)z^{-1} + z^{-2})(1 + z^{-1})}{(1 + B_{(1,1)}z^{-1} + B_{(1,2)}z^{-2})(1 + B_{(2,1)}z^{-1} + B_{(2,2)}z^{-2})(1 + B_{(3,1)}z^{-1})} \quad (15)$$

yielded by transforming the transfer function shown by the equation (10) to a transfer function in the s region by the bilinear transformation of the equation (4), and further to become a product of the quadratic expresion. Each coefficient

is as shown in Fig. 12. Fig.13 shows the behavior of logarithmic amplitude characteristics of the secondary cascade digital filter with respect to the word lengths thereof.

It is evident from the comparison of Fig. 11 with Fig. 13 that the characteristic of the first embodiment of the digital filter according to the present invention is more ideal than that of the conventional secondary cascade digital filter under the same word length and thus coefficient sensitivity of the former is lower than that of the latter.

Let us describe in succession sensitivity of the digital filter with respect to the internal operation word length thereof.

Fig. 14 shows relative error (err) between gains of the digital filter of Fig. 8 and the secondary cascade digital filter of Fig. 12 as internal operation word lengths thereofare reduced. The relative error (err) is here shown by

$$err(dB) = \frac{1}{N} \sum_{k=1}^{N} \left| GA_0(k) - GA(k) \right| \qquad (16)$$

where N : a number of samples in the pass band,

GAo: gain (dB) of the pass band of a reference filter (in case of no limitation to the coefficient word length and the internal operation word length), and

GA : gain (dB) of a filter to be compared.

It is clearly shown from Fig. 14 that the first embodiment of the digital filter according to the present invention can be reduced in sensitivity to the internal operation word length as compared with the conventional cascade digital filter.

Although the first embodiment of the digital filter according to the present invention is constructed as a digital filter having in combination delay means, adder means, and multiplier means based on an equation capable of delaying any concerning signal, with the use of which equation a node equation of the analog filter is s - z transformed to provide node voltage, the arrangement of the digital filter can be assured also from a closed circuit equation of the analog filter.

Let us here describe a second embodiment of the digital filter according to the present invention wherein the digital filter is constructed based on a closed circuit equation of the analog filter.

The second embodiment will be provided following procedures described below.

The closed circuit equation of an LC analog filter shown in Fig. 15 is represented in general by

$$\begin{pmatrix} E \\ 0 \\ \vdots \\ 0 \end{pmatrix} = \begin{pmatrix} z_{11} & \cdots\cdots & z_{1n} \\ z_{21} & & z_{2n} \\ & \cdots\cdots & \\ z_{n1} & \cdots\cdots & z_{nn} \end{pmatrix} \begin{pmatrix} I_1 \\ I_2 \\ \vdots \\ I_n \end{pmatrix} \qquad (21)$$

Here, $z_{ij}$ in the above equation can be expressed by

$$z_{ij} = R_{ij} + sL_{ij} + \frac{1}{sC_{ij}} \qquad (22)$$

in terms of resistance $R_{ij}$, capacitance $C_{ij}$ and inductance $L_{ij}$.

In addition, E is electromotive force, $R_i$ internal registance, and $I_i$ ($i = 1, 2, \ldots\ldots n$) a closed circuit current independent from each other. The above equation (21) can be expressed as

$$E = \left[R_{ij} + sL_{ij} + \frac{1}{sC_{ij}}\right]\mathbf{I} \qquad (23)$$

by using the expression (22), where

$$E = \begin{pmatrix} E \\ 0 \\ \vdots \\ 0 \end{pmatrix}, \qquad \mathbf{I} = \begin{pmatrix} I_1 \\ I_2 \\ \vdots \\ I_n \end{pmatrix}$$

Then, bilinear s - z transformation

$$s = \frac{2}{T}\,\frac{1 - z^{-1}}{1 + z^{-1}} \qquad (24)$$

is applied to the equation (23). Here s, represents a complex variable of the transfer function $H_A(s)$ of the analog filter, z a complex variable of the transfer function $H_D(z)$ of the digital filter, and T a sampling interval.

Moreover, substituting the equation (24) for the equation
(23) and putting it in order,

$$(1 - z^{-2})E = \left[(R_{ij} + L_{ij}\frac{T}{2} + \frac{1}{C_{ij}}\frac{2}{T}) + (\frac{1}{C_{ij}}\frac{T}{2} - L_{ij}\frac{2}{T})2z^{-1} + (\frac{1}{C_{ij}}\cdot\frac{1}{2} + L_{ij}\frac{T}{2} - R_{ij})z^{-2}\right]I \qquad (25)$$

is yielded.

$$(A) = \left[R_{ij} + L_{ij}\frac{T}{2} + \frac{1}{C_{ij}}\frac{2}{T}\right]$$

and multiplying both sides of the equation by the inverse matrix $(A)^{-1}$ of the matrix (A) from the left,

$$(1 - z^{-2})(A)^{-1}E = I + 2z^{-1}(A)^{-1}\left[\frac{1}{C_{ij}}\frac{T}{2} - L_{ij}\frac{2}{T}\right]I + z^{-2}(A)^{-1}\left[\frac{1}{C_{ij}}\frac{1}{2} + L_{ij}\frac{2}{T} - R_{ij}\right]I \qquad (26)$$

is obtained. In addition, putting this in order and transforming this into a form to derive the closed circuit current $I$

$$I = (1 - z^{-2})(B)E + z^{-1}(C)I + z^{-2}(D)I \qquad (27)$$

is yielded, where

$$(B) = (A)^{-1}, \qquad (C) = -2(A)^{-1}\left(\frac{1}{C_{ij}}\frac{T}{2} - L_{ij}\frac{2}{T}\right),$$

$$(D) = -(A)^{-1}\left[\frac{1}{C_{ij}}\frac{1}{2} + L_{ij}\frac{2}{T} - R_{ij}\right]$$

Moreover, (i, j) elements of the matrixes (B), (C), and (D) are assumed to the $b_{ij}$, $c_{ij}$, and $d_{ij}$ respectively.

The matrix (27) includes n equations, the kth one among which is given as

$$I_k(z) = b_{k1}G_0E(z)\cdot(1 - z^{-2}) + \sum_{j=1}^{n} C_{kj}I_j(z)\cdot z^{-1} + \sum_{j=1}^{n} d_{kj}I_j(z)\cdot z^{-2} \qquad (28)$$

A difference equation derived from this equation is

$$i_k(mT) = b_{k1}G_0\{e(mT) - e((m-2)T)\} + \sum_{i=j}^{n} C_{kj}i_j((m-1)T) + \sum_{j=1}^{n} d_{kj}i_j((m-2)T) \qquad (29)$$

Here, ik(mT) and e(mT) are respectively inverse z transformations of $I_k(z)$ and E(z). The equation (29) serves to evaluate $i_k(mT)$ from $\upsilon_j((m-1)T)$, $\upsilon_j((m-2)T)$ (j = 1, 2, ......n) and [e(mT)-e(m-2)T], and can be represented by a circuit shown in Fig. 16. Thus, the equation (27) forms in all n circuits to evaluate $i_k(mT)$ for k from 1 to n including delay elements. Output voltage $V_o$ needed as the filter is given by multiplying the sum of closed circuit currents flowing through an output resister $R_o$ and thusa digital filter shown in Fig.

17 is finally provided.

It is obvious from Fig. 17 and the equation (29) that the matrix element (ij) at the same time, i.e., $i_j(mT)$ is not needed to obtain arbitrary $i_k(mT)$. Namely, the filter can be constructed without producing DFL.

Furtheremore, the above method to construct the digital filter can also be applied to a filter yielded by use of a circuit element having a dimension more than the square of s as an original analog filter and capable of being transformed to an LCR filter by impedance scaling.

In addition, a digital filter without DFL can be realized in the same manner even with use of other known s - z transformation, e. g., $s = z^{-1}/(1 + z^{-1})$, $s = 1 - z^{-1}$, and $s = (z^2 - dz + 1)/(z^2 - 1)$, etc. instead of the s - z transformation of the equation (24).

Subsequently, let us describe as an exemplification, a case wherein a fifth polarized low-pass filter shown in Fig. 18 is transformed to a digital filter based on the construction method for the digital filter described above.

An analog transfer function $H_A(s)$ of the fifth polarized low-pass filter of Fig. 18 (cut-off frequency: 1 $MH_z$, allowable ripple contents of the pass band: 0.28dB, attenuation pole frequencies: 1.369345 $MH_z$, 1.988127 $MH_z$) is given as

$$H_A(s) = \frac{1}{2} \frac{A_4 s^4 + A_2 s^2 + 1}{B_5 s^5 + B_4 s^4 + B_3 s^3 + B_2 s^2 + B_1 s + 1}$$

where

$$A_2 = 0.01991716490$$

$$A_4 = 8.656982093 \times 10^{-5}$$

$$B_1 = 0.4692808372$$

$$B_2 = 0.1158863247$$

$$B_3 = 0.02345920748$$

$$B_4 = 2.200704185 \times 10^{-3}$$

$$B_5 = 2.594782157 \times 10^{-4} \qquad (30)$$

Effecting the bilinear s - z transformation shown by the equation (24) for the analog transfer function $H_A(s)$ described above, frequency distortion is caused between analog and digital frequencies. A relation

$$\frac{\omega_A T}{2} = \tan \frac{\omega_D T}{2} \qquad (31)$$

is yielded between circular frequencies $\omega_A$ and $\omega_D$ respectively in the analog and digital regions from the equation (24) as shown in Fig. 19.

To eliminate the influence of nonlinear distortion on the frequencies described above, the frequency axis of the analog filter is changed beforehand. Namely, parameters of elements of the analog filter are altered to shift the cut-off frequency with use of the equation(31) so as to permit a desired cut-off frequency of a digital filter to be obtained.

In the above example, assuming the sampling period to be T = 0.1($\mu$s), the cut-off frequency of digital filter is $f_D$ = 1 $MH_z$ and the cut-off frequency $f_A$ of the analog

filter must satisfy

$$f_A = \frac{1}{\Pi T} \tan (\Pi f_D T) = 1.03425152 (MHz)$$

from the equation (31) to provide the cut-off frequency of the digital filter of $f_D$ = 1 $MH_Z$. For that, capacitances and inductances of the circuit shown in Fig. 18 must be multiplied by $f_D/f_A$, respectively. The circuit so obtained is shown in Fig. 20.

Assuming closed circuit currents flowing through this circuit as shown in Fig. 20, a closed circuit equation is as follows:

$$\begin{pmatrix} E \\ 0 \\ 0 \end{pmatrix} = \begin{pmatrix} R_0 + s(L_1 + L_2) + \frac{1}{sC_1} & -sL_2 - \frac{1}{sC_1} & 0 \\ -sL_2 - \frac{1}{sC_1} & s(L_2 + L_3 + L_4) + \frac{1}{s}\left(\frac{1}{C_1} + \frac{1}{C_2}\right) & -sL_4 - \frac{1}{sC_2} \\ 0 & -sL_4 - \frac{1}{sC_2} & R_0 + s(L_4 + L_5) + \frac{1}{sC_2} \end{pmatrix} \begin{pmatrix} I_1 \\ I_2 \\ I_3 \end{pmatrix} \tag{32}$$

Subjecting the equation to the bilinear transformation and arranging the resultant equation to order in conformity with the procedure described previously,

$$\begin{pmatrix} I_1 \\ I_2 \\ I_3 \end{pmatrix} = \begin{pmatrix} b_{11} \\ b_{21} \\ b_{31} \end{pmatrix} E(1 - z^{-2}) + \begin{pmatrix} c_{11} & c_{12} & c_{13} \\ c_{21} & c_{22} & c_{23} \\ c_{31} & c_{32} & c_{33} \end{pmatrix} \begin{pmatrix} I_1 \\ I_2 \\ I_3 \end{pmatrix} z^{-1}$$

$$+ \begin{pmatrix} d_{11} & d_{12} & d_{13} \\ d_{21} & d_{22} & d_{23} \\ d_{31} & d_{32} & d_{33} \end{pmatrix} \begin{pmatrix} I_1 \\ I_2 \\ I_3 \end{pmatrix} z^{-2} \qquad (33)$$

is yielded where values of the coefficients are shown in Fig. 21.

The d.gital filter is thus constructed as shown in Fig. 22 following three difference equations yielded from the equation (33).

In succession, logarithmic amplitude characteristric of the original fifth polarized low-pass filter of Fig. 18 and that of the digiatl filter of Fig. 16 yielded as the result of the transformation will be evaluated respectively as shown below.

a. Logarithmic Amplitude characteristic of the Original Fifth Polarized Low-Pass Filter.

The transfer function $H_A(s)$ in the s region of the equation (30) is, after previously corrected in its frequency distortion produced due to the biliniar s - z

0194318

transformation as shown before, subjected to the bilinear s - z transformation. For the resaltant transfer function $H_D(z)$ in the s region,

$$z = e^{j\Omega} \tag{34}$$

is substituded and thereby the logarithmic amplitude characteristic can be evaluated with use of an expression $20\log_{10}|H_D(e^{j\Omega})|$ (dB). Fig. 23 shows the evaluated logarithmic amplitude characteristic.

b. Logarithmic Amplitude Characteristic of the Digital Filter Shown in Fig. 22.

Entering a unit sample series into an input of the digital filter of Fig. 22 to obtain impulse response and thereafter subjecting it fast Fourier transformation, the logrithmic amplitude characteristic can be yielded. Fig. 24 shows a logarithmic amplitude characteristic when the filter coefficient of the digital filter is represented with use of binary floating point representation and only the fixed-point part is rounded to a specified word length. For an internal operation format, a single accuracy real number format (exponent: 8 bits, fixed-point part: 24 bits) is employed.

It is formed from Figs. 23 and 24 that the amplitude characteristic of the second embodiment of the digital filter according to the present invention is very excellently coincident with that of the original analog filter.

Then, let us describe coefficient sensitivity of the digital filter.

A digital filter shown in Fig. 22 is yielded by applying the construction method in conformity with the second embodiment of the present invention to the fifth polarized low-pass filter of Fig. 18 as described above. Changes of the logarithmic amplitude characteristic of the above digital filter with respect to the word length of the multiplication coefficient thereof are shown in Fig. 25. A digital filter shown in Fig. 26 is exemprary transformation of the above fifth polarized low-pass filter to a secondary cascade digital filter typical of a conventional one. The secondary cascade digital filter is constructed based on a transfer function

$$H(z) = A_0 \frac{(1+A_{(1)}z^{-1}+z^{-2})(1+A_{(2)}z^{-1}+z^{-2})(1+z^{-1})}{(1+B_{(1,1)}z^{-1}+B_{(1,2)}z^{-2})(1+B_{(2,1)}z^{-1}+B_{(2,2)}z^{-2})(1+B_{(3,1)}z^{-1})} \quad (35)$$

derived by transforming the transfer function of the equation (30) to a transfer function in the z region in conformity with the bilinear transformation of the equation (24), and furtheremore factorizing it to provide a product of quadratic expressions. Coefficient values are as shown in Fig. 26. Fig. 27 shows changes of the logarithmic amplitude characteristic of the above secondary cascade digital filter with respect to the word length of the multiplication coefficient thereof.

It is understood by comparison of Fig. 25 with FJig. 27 that the characteristic of the digital filter according to the construction method of the present invention is more ideal with respect to the same word length as compared with the prior one, and thus the coefficient sensitivity can be reduced.

Let us then describe the sensitivity of the digital filter to the internal operation word length thereof.

Fig. 28 shows a relative error (err) of gains of the digital filter of Fig. 22 and the secondary cascade digital filter of Fig. 26 as the internal operation word lengths thereof are reduced. The relative error (err) is as follows.

$$err(dB) = \frac{1}{N} \sum_{k=1}^{N} \left| G \cdot A_0(k) - GA(k) \right| \qquad (36)$$

where

N: the number of samples within the pass band

$GA_O$: a gaing (dB) of the pass band of a reference filter (not limited in coefficient word length and internal operation word length )

GA: a gain (dB) of a filter to be compared.

As is clearly shown in Fig. 28, the second embodiment of the digital filter according to the present invention can be constructed to be less sensitive to the internal operation word length as compared with that of the prior cascade digital filter.

The digital filters being the first and the second embodiments of the present invention were adapted to be a digital filter comprising in combination the delay means, adder means, and multiplier means, by subjeting a mode equation or a closed circuit equation of an analog filter to s - z transfotmation . The arrangement of this digital filter may also be constructed by, after transforming inductance of any analog filter with use of an equivalent circuit comprising resistors and capacitors each having positive and negative resistance and capacitance values, subjecting a node equation or a closed circuit equation on the equivalent circuit to s - z transformation. This will be described below as a third embodiment.

A digital filter being the third embodiment of the present invention is constructed by deriving a node equation for a circuit yielded by transforming inductance of an LC analog filter with use of the equivalent circuit comparising resitors and capacitors each having positive and negative resistance and capacitance values, and applying s - z transformation being bilinear transformation to derive a difference equation.

This equivalent transformation is achieved by transforming inductance L of an analog filter of Fig. 29(a) to resistance R and capacitance $L_C$ of (c) of the same figure while transforming (b) of the same figure to (d) in the same manner.

The node equation after this equivalent transformation can be represented in general as the following equation (41).

$$\begin{pmatrix} g_0E \\ 0 \\ \vdots \\ 0 \end{pmatrix} = \begin{pmatrix} (G) + s(C) \end{pmatrix} \begin{pmatrix} V_1 \\ \vdots \\ V_n \end{pmatrix}$$

Here, designated as E is input voltage to the filter, $V_i$(i = 1, 2, ..., n) is node voltage, n is the number of nodes of the circuit, g is conductance, and (G) and (C) are respectibely n x n square matrices wherein each element of (G) is positive or negative conductance and each elemtaelement of (C) positive or negative capacitance. Then, bilinear transformation

$$s = \frac{2}{T} \frac{1 - z^{-1}}{1 + z^{-1}} \qquad (42)$$

is applied to the node equation of (1). Here, designated as s is a complex variable of a transfer function $H_A(s)$ of the analog filter, z is a complex variable of a transfer function $H_D(z)$ of the digital filter, and T is a sampling interval.

Substituting (42) for (41), and putting the resultant expression in order,

$$\begin{pmatrix} g_0E \cdot (1 + z^{-1}) \\ 0 \\ \vdots \\ \vdots \\ 0 \end{pmatrix} = \begin{pmatrix} \left\{(G) + \frac{2}{T}(C)\right\} + \left\{(G) - \frac{2}{T}(C)\right\}z^{-1} \end{pmatrix} \cdot \begin{pmatrix} V_1 \\ V_2 \\ \vdots \\ \vdots \\ V_n \end{pmatrix} \qquad (43)$$

is obtained.

Here, putting

$$E = [g_0E\ 0\ldots 0]^T \quad , \quad V = [V_1\ V_2\ \ldots\ V_n]^T \tag{44}$$

(where $[\ ]^T$ denotes inversion of a matrix [ ].), (43) becomes

$$E(1 + z^{-1}) = [\left\{(G) + \frac{2}{T}(C)\right\} + \left\{(G) - \frac{2}{T}(C)\right\}z^{-1}]V \tag{45}$$

Multiplying both sides of (45) by $\left\{(G) + \frac{2}{T}(C)\right\}^{-1}$ from the left,

$$\left\{(G) + \frac{2}{T}(C)\right\}^{-1} E(1 + z^{-1})$$

$$= [I + \left\{(G) + \frac{2}{T}(C)\right\}^{-1} \left\{(G) - \frac{2}{T}(C)\right\} z^{-1}]V \tag{46}$$

is obtained. Here, I signifies a n x n unit matrix.

Developing (46) and putting the resultant expression in order, an equation providing the mode voltage V and having proper delay, i. e.,

$$V = (A)E(1 + z^{-1}) - (B)z^{-1}V \tag{47}$$

can be obtained. Here, it becomes

$$(A) = [(G) + \frac{2}{T}(C)]^{-1} = (a_{ij}), i,j = 1,\ldots, n$$

$$(B) = [(G) + \frac{2}{T}(C)]^{-1}\ [(G) - \frac{2}{T}(C)] = (b_{ij}), i,j = 1, \ldots, n \tag{48}$$

 

Accordingly, a difference equation for the node voltage $V_k (k = 1, ..., n)$ becomes

$$\upsilon_k(nT) = a_{k1} g_0 \{e(nT) + e((n-1)T)\} - \sum_{j=1}^{n} b_{kj} \upsilon_j ((n-1)T) \qquad (49)$$

Here, $\upsilon_k(nT)$ and $e(nT)$ respectively signify inverse z transformation of $V_k = V_k(z)$ and $E = E(z)$.

Fig. 30 shows the arrangement of the digital filter of the third embodiment of the present invention in case of the number of nodes n = 4, derived based on the equation (49). An input $E\ell$ entered from an input terminal 31 at the time $\ell T$(T: a sampling interval, $\ell$:arbitrary integer) is supplied to one of input terminals of an adder 33, while supplied to a delay element 34. The adder 33 adds the input signal and an output $E\ell_{-1}$ from the delay element 34, and an output from the adder 33 is multiplied in a multiplier 35 - m (m = 1, ..., 4) by $a_{m1}$ and entered into one of five input terminals of an adder $36_{-m}$(m =1, .., 4). The other four inputs are as follows: For example, an output from the adder $36_{-1}$ is delayed by one sampling interval T through a delay element $37_{-1}$ and multiplied by $-b_{11}$, $-b_{21}$, $-b_{31}$, and $-b_{41}$ in multipliers $38_{-11}$, $38_{-21}$, $38_{-31}$, and $38_{-41}$ respectively. Outputs from all multipliers are entered into the adders $36_{-1}$, $36_{-2}$, $36_{-3}$, and $36_{-4}$ respectively. The same operation is concurrently executed for outputs $V_2$, $V_3$, and $V_4$ from the adders $36_{-2}$, $36_{-3}$, and $36_{-4}$.

The other four inputs to each adder are yieled as described above. Outputs from the filter can be delivered from the output terminal 32. But, coefficients of each multiplier have previously been determined by the equation (48). It is clearly shown from (49) or Fig. 30 that $\dot{u}_j(nT)$ at the same time is not needed to obtain arbitray $\upsilon_k(nT)$. Namely, the digital filter can be assured without DFL.

In addition, a closed circuit equation can be employed instead of the node equation of (41). Namely,

$$\begin{pmatrix} E \\ 0 \\ \vdots \\ 0 \end{pmatrix} = [(R) + \frac{1}{s}(D)] \begin{pmatrix} I_1 \\ I_2 \\ \vdots \\ I_n \end{pmatrix}$$

or with transformation,

$$\begin{pmatrix} sE \\ 0 \\ \vdots \\ 0 \end{pmatrix} = [s(R) + (D)] \begin{pmatrix} I_1 \\ I_2 \\ \vdots \\ I_n \end{pmatrix}$$

is obtained instead of the equation (41). Here, (R) and (D) are respectively n x n square matrices, and each element of (R) is a reciprocal of positive or negative resistance, while that of (D) is a reciprocal of positive or negative capacitance. Accordingly, it is found that a digital filter without DFL can be constructed in the same manner as described above with use of the procedures described from the equation (42) on. It is furthermore

0194318

obvious that a digital filter without DFL can be assured also when using another known s - z transformation instead of the s - z transformation given by the equation (42). Then, let us show an exmaprary design for a concrete digital filter. Fig. 31 is a fifth polarized low-pass filter. An analog transfer function $H_A(s)$ of this low-pass filter (cut-off frequency : 1 MHz, allowable ripple conteents of the pass band : 0.28 dB, and attenuation pole frequencies : 1.369345 and 1.988127 MHz) is given as

$$H_A(s) = \frac{A_4 s^4 + A_2 s^2 + 1}{B_5 s^5 + B_4 s^4 + B_3 s^3 + B_2 s^2 + B_1 s + 1}$$

where

$$A_2 = 0.01991716489697047$$
$$A_4 = 8.656982092718226 \times 10^{-5}$$
$$B_1 = 0.4692808371624611$$
$$B_2 = 0.1158863246587944$$
$$B_3 = 0.0234592074798037$$
$$B_4 = 2.200704184590143 \times 10^{-3}$$
$$B_5 = 2.594782156707019 \times 10^{-4} \qquad (50)$$

Although this analog filter will be transformed to a digital filter following the design procedures described before, frequency distortion is caused in that case between analog frequency and digital frequency upon effecting the bilinear transformation shown by the equation (42). Namely, from (42) a relation

$$\frac{\omega_A T}{2} = \tan\left(\frac{\omega_D T}{2}\right) \qquad (51)$$

holds beteween circular frequency $\omega_A$ in the analog region and circular frequency $\omega_D$ in the digital region. Fig. 32 shows this relation. From the same figure, it is evidenced that circular frequencies $\omega_D$ and $\omega_A$ are in a nonlinear relation. To eliminate this, it is necessary to change previously the frequency axis of the analog filter. In fact, element parameters of the digital filter to be designed are altered so as to provide a desired cut-off frequency of the digital filter with use of (51). In the above example, with the sampling period T=0.1 (μs) analog cut-off frequency $f_A$ must satisfy

$$f_A = \frac{1}{\Pi T} \tan(\Pi f_D T) = 1.03425152\,(\text{MHz})$$ .

from (51) to permit cut-off frequency of the digital filter $f_D = 1$ MHz to be yieled. For this, capacitance and inductance of the fifth polarized low-pass filter shown in Fig. 31 are multiplied respectively by $f_D/f_A$ and $f_A/f_D$ Then, equivalent transformation of the inductance of Fig. 29 is conducted to obtain an equivalent circuit shown in Fig. 33. A node equation of this circuit becomes

$$\begin{pmatrix} E \\ 0 \\ 0 \\ 0 \\ 0 \end{pmatrix} = \begin{pmatrix} s(C_1+C_2)+1 & -1 & -sC_2 & 0 & 0 \\ 1 & sL_1 & -1 & 0 & 0 \\ -sC_2 & 1 & s(C_1+C_2+C_3) & -1 & -sC_4 \\ 0 & 0 & 1 & L_2 & -1 \\ 0 & 0 & -sC_4 & 1 & s(C_4+C_5)+1 \end{pmatrix} \begin{pmatrix} V_1 \\ V_2 \\ V_3 \\ V_4 \\ V_5 \end{pmatrix}$$

Subjecting the above expression to bilinear transformation, and developing and putting in order the resultant expression following the procedure described before,

$$\begin{pmatrix} V_1 \\ V_2 \\ V_3 \\ V_4 \\ V_5 \end{pmatrix} = \begin{pmatrix} a_{11} \\ a_{21} \\ a_{31} \\ a_{41} \\ a_{51} \end{pmatrix} E(1+z^{-1}) - \begin{pmatrix} b_{11} & b_{12} & b_{13} & b_{14} & b_{15} \\ b_{21} & b_{22} & b_{23} & b_{24} & b_{25} \\ b_{31} & b_{32} & b_{33} & b_{34} & b_{35} \\ b_{41} & b_{42} & b_{43} & b_{44} & b_{45} \\ b_{51} & b_{52} & b_{53} & b_{54} & b_{55} \end{pmatrix} z^{-1} \begin{pmatrix} V_1 \\ V_2 \\ V_3 \\ V_4 \\ V_5 \end{pmatrix} \quad (53)$$

holds. Here, coefficients are as shown in Table 1. A difference equation is

$$\upsilon_k(nT) = a_{k1}\{e(nT) + e((n-1)T)\} - \sum_{j=1}^{5} b_{kj}\upsilon_j((n-1)T) \quad , k = 1, \ldots, 5 \qquad (54)$$

from (53). Fig. 34 shows a digital filter yielded on the basis of this difference equation. Theoretical and experimental values of logarithmic amplitude characteristics of the digital filter so obtained are respectively provided as follows.

TABLE 1

| i \ j | $a_{ij}$ | $b_{ij}$ | | | | |
|---|---|---|---|---|---|---|
| | 1 | 1 | 2 | 3 | 4 | 5 |
| 1 | 0.17253383 | -0.55318705 | -0.24610227 | -0.077569021 | -0.082288302 | $-7.4991753\times10^{-3}$ |
| 2 | -0.050872645 | 0.65592113 | -0.83264917 | -0.74163964 | -0.054550058 | $-4.9713074\times10^{-3}$ |
| 3 | 0.049482698 | 0.033359861 | 0.15868716 | -0.87145249 | -0.21423439 | -0.019523811 |
| 4 | -0.012088135 | $-8.1494848\times10^{-3}$ | -0.038765706 | 0.52704223 | -0.84843353 | -0.45444451 |
| 5 | $8.3385470\times10^{-3}$ | $5.6216169\times10^{-3}$ | 0.026741070 | -0.077569021 | 0.30164950 | -0.56630784 |

The transfor function $H_A(s)$ in the s region of (59) is subjected to bilinear transformation of the correcting the frequency distortion thereof caused by the bilinear transformation as described above, and

$$z = e^{j\Omega} \quad (55)$$

is subjected for the resultant transfer function H(z) in the z region. Thuys, a desited theoritical characteristics are yielded through $20\log_{10}|H(e^{j\Omega})|$(dB).

[Experimental Logarithmic Amplitude Characteristics]

Logarithmic amplitude characteristics are derived by entering a unit sample series into an input of a filter of Fig. 34 yieled according to the present construction method to provide an impulse responce thereof, and subjecting it to fast Fourier transformation. Thereupon, coefficient of the digital filter is represented with use of binary floating point representation, and only a fixed point part thereof is rounded into a designated word length. For an internal operation format, (exponet : 8 bits, fixed point part : 24 bits) of floating point representation is employed.

Figs. 35 and 36 show respectively theoritical logarithmic amplitude characteristics and experimental ones when the filter coefficient is 23 bits. Fig. 37 furthermore shows changes of the characteristics with respect to word lenghts of a multiplication coefficient.

In succession, a typical cascade digital filter and a digital filter according to the present construction method will be compared. And, all digital filter according to the present construction method will be shown to be constructed with low coefficient sensitivity and reduced internal operation word lentgh. Fig. 38 shows a secondary cascade digital filter. The digital filter is consturcted based on a transfer function

$$H(z)=A_0\frac{(1+A_{(1)}z^{-1}+z^{-2})(1+A_{(2)}z^{-1}+z^{-2})(1+z^{-1})}{(1+B_{(1,1)}z^{-1}+B_{(1,2)}z^{-2})(1+B_{(2,1)}z^{-1}+B_{(2,2)}z^{-2})(1+B_{(3,1)}z^{-1})} \quad (52)$$

yieled by transforming the trasfer function of the equation (50) to a transfer function in the z region through the bilinear transformation of the equation (42) and furthermore factorizing the latter transfer function to obtain the product of quadratic equations. Fig. 39 shows changes of the logarithmic amplitude characteristics of the cascade digital filter of Fig. 38 due to the word lenghts of the multiplication coefficient thereof.

Comparison between coefficient sensitivies of the cascade digital filter and the digital filter of the third embodiment of the present invention is shown by a relative error (err) of

$$err(dB) = \frac{1}{N}\sum_{k=1}^{N}|GA_0(k) - GA(k)| \quad (57)$$

where

N : the number of samples in the pass band,

$GA_o$ : a gain (dB) of the pass band of a reference filter

(coefficient : 23 bits, internal operation word length : 24 bits)

GA : a gain (dB) of a filter to be compared.

Fig. 40 shows a result of the above description. It is found from the figure that the digital filter of the third emboidiment of the present invention is more reduced in the coefficient sensivity than that of the prior art cascade digital filter.

Finally, table-2 shows ripple widths within the band and relative errors versus internal operation word lengths of the cascade digital filter and digital filter of the third embodiment of the present invention. It is evidenced from the figure that the digital filter of the third embodiment of the present invention is more reduced in sensitivity to the internal operation word length than that of the cascade digital filter.

| Coefficient Word Length | Operation Word Length | Filter according to Third Embodiment | | Conventional Cascase Filter | |
|---|---|---|---|---|---|
| | | Ripple Widths (dB) | Relative Error (dB) | Ripple Widths (dB) | Relative Error (dB) |
| 12 | 12 | 0.291 | 0.0090 | 0.305 | 0.0135 |
| | 11 | 0.287 | 0.0109 | 0.305 | 0.0156 |
| | 10 | 0.325 | 0.0366 | 0.306 | 0.0543 |
| | 9 | 0.382 | 0.0661 | 0.342 | 0.0816 |
| | 8 | 0.450 | 0.1701 | 0.411 | 0.1638 |
| | 7 | 0.369 | 0.1535 | 0.836 | 0.2381 |
| 10 | 12 | 0.296 | 0.0147 | 0.371 | 0.0351 |
| | 11 | 0.295 | 0.0192 | 0.371 | 0.0308 |
| | 10 | 0.328 | 0.0279 | 0.358 | 0.0266 |
| | 9 | 0.401 | 0.0907 | 0.368 | 0.0642 |
| | 8 | 0.483 | 0.1666 | 0.475 | 0.1283 |
| | 7 | 0.366 | 0.1536 | 0.568 | 0.2461 |
| 8 | 12 | 0.388 | 0.0185 | 0.308 | 0.0231 |
| | 11 | 0.368 | 0.0157 | 0.305 | 0.0283 |
| | 10 | 0.345 | 0.0137 | 0.355 | 0.0795 |
| | 9 | 0.312 | 0.0249 | 0.458 | 0.0705 |
| | 8 | 0.292 | 0.0442 | 0.469 | 0.1491 |
| | 7 | 0.361 | 0.0984 | 0.795 | 0.3039 |
| 6 | 12 | 0.343 | 0.0256 | 0.953 | 0.2130 |
| | 11 | 0.312 | 0.0351 | 0.975 | 0.2079 |
| | 10 | 0.317 | 0.0579 | 0.946 | 0.2037 |
| | 9 | 0.328 | 0.0759 | 0.987 | 0.1805 |
| | 8 | 0.428 | 0.1828 | 1.183 | 0.3239 |
| | 7 | 0.414 | 0.1536 | 0.891 | 0.2326 |
| 4 | 12 | 0.840 | 0.3682 | 4.441 | -1.0390 |
| | 11 | 0.829 | 0.3585 | 4.391 | 1.0389 |
| | 10 | 0.792 | 0.3368 | 4.447 | 1.0518 |
| | 9 | 0.749 | 0.3276 | 4.375 | 1.0663 |
| | 8 | 0.657 | 0.2679 | 4.560 | 1.0322 |
| | 7 | 0.554 | 0.2172 | 4.126 | 0.9589 |

The digital filter according to the present invention can be phsically constructed in combination without fail with no DFL. In addition, the digital filter according to the present pinvention can be more reduced in sensitivity to internal operation word length and the filter coefficient sensitivity as compared with a prior art typical cascade digital filter.

A highly accurate filter according to the present invention, as described above, can be profitably employed as a filter for extracting and eliminating a signal in a frequency domain.

Although certain preferred embodiments have been shown and described, it should be understood that many changes and modifications may be made therein without departing from the scope of the appended claims.

0194318

CLAIMS

1. A digital filter composed of in combination adder means (2), multiplier means (3), and delay means (1), said digital filter comprising:

(a) a means for deriving a node equation of an analog filter for transforming said analog filter to said digital filter,

(b) a tranforming means for subjecting said node equation to s-z transformation to provide an equation projected on a z-plane, and

(c) a means for allowing said equation projected on the z-plane to be employed as an equation providing node voltage and having delay, said combination among said adder menas (2), said multiplier means (3), and said delay means (1) being determined by said equation providing the node voltage and having the delay.

2. A digital filter according to claim 1 wherein said node equation is given as

$$\begin{bmatrix} \frac{1}{R_0} E \\ 0 \\ \vdots \\ 0 \end{bmatrix} = [G_{ij} + sC_{ij} + \frac{1}{sL_{ij}}] \begin{bmatrix} V_1 \\ V_2 \\ \vdots \\ V_n \end{bmatrix} \quad (i,j = 1,2...n)$$

where E is electromotive force, $R_o$ being terminal resistnace, $G_{ij}$ being condactance, $C_{ij}$ inductance, $V_i$

being node voltage, s being a complex variable of the transfer function $H_A(s)$ of an analog filter.

3. A digital filter according to claim 2 wherein said s - z transformation is given as

$$s = \frac{2}{T}\frac{1 - z^{-1}}{1 + z^{-1}}$$

where s is a complex variable of the transfer function $H_A(s)$ of the analog filter, z being a complex variable of the transfer function $H_D(z)$ of the digital filter, T being a sampling interval.

4. A digital filter composed of the combination of adder means (2), multiplier means (3), and delay means (1), said digital filter comprising:

(a) a means for derriving a closed circuit equation of an analog filter for transforming said analog filter to said digital filter,

(b) a transforming means for subjecting said closed circuit equation to s-z transformation and for thereby providing an equation projected on an s-plane, and

(c) a means for allowing said equation projected on said z-plane to be employed as an equation providing a closed circuit current and having delay, said adder means (2), said multiplier means (3), and said delay means (1) being determined by said equation providing the closed circuit current and having the delay.

5. A digital filter according to claim 4 wherein said closed circuit equation is given as

$$\begin{pmatrix} E \\ 0 \\ \vdots \\ 0 \end{pmatrix} = [R_{ij} + sL_{ij} + \frac{1}{sC_{ij}}] \begin{pmatrix} I_1 \\ I_2 \\ \vdots \\ I_n \end{pmatrix} \quad (i, j = 1, 2...n)$$

where E is electromotive force, $R_{ij}$ being registance, $C_j$ being capacitance, $L_{ij}$ being inductance, $I_i$ being a closed circuit current, s being a complex variable of the transfer function of the analog filter.

6. A digital filter according to claim 5 wherein said s - z transformation is given as

$$s = \frac{2}{T} \frac{1 - z^{-1}}{1 + z^{-1}}$$

where s is a complex variable of a transfer function $H_A(s)$ of an analog filter, z being a complex variable of a transfer function $H_D(z)$ of the digital filter, T being a sampling interval.

7. A digital filter composed of in combination adder means (2), multiplier means (3), and delay means (1), said digital filter comprising:

(a) a means for transforming inductance of said analog filter to be transformed to said digital filter to an equivalent circuit including resistors and capacitors each having positive and negative resistances and capacitances,

(b) a means for deriving a node equation of said equivalent circuit,

(c) a means for subjecting said node equation of s - z transformation and for thereby providing an equation projected on a z-plane, and

(d) a means for providing said equation projected on the z-plane as an equation providing node voltage and having delay, said adder means (2), said multiplier means (3), and said delay means (1) in combination being determined by said equation providing the node voltage and having the delay.

8. A digital filter according to claim 7 wherein said node equation is given as

$$\begin{pmatrix} g_0E \\ 0 \\ \vdots \\ 0 \end{pmatrix} = [G_{ij} + sC_{ij}] \begin{pmatrix} V_1 \\ V_2 \\ \vdots \\ V_n \end{pmatrix} \quad (i,\ j = 1,2...n)$$

where $g_o$ is conductance, E electromotive force, $G_{ij}$ conductance, $C_{ij}$ capacitance, $V_i$, node voltage, and s a complex variable of a transfer function $H_A(s)$ of the analog filter.

9. A digital filter according to claim 8 wherein said s - z transformation is given as

$$s = \frac{2}{T}\frac{1 - z^{-1}}{1 + z^{-1}}$$

where s is a complex variable of the transfer function $H_A(s)$ of the analog filter, z a complex variable of a transfer function $H_D(z)$ of the digital filter, and T a sample interval.

10. A digital filter composed of in combination adder means (1), multiplier means (3), and delay means (1), said digital filter comprising:

(a) a means for transforming inductance of an analog-filter to be transformed to said digital filter to an equivalent circuit including resistors and capacitors each having positive and negative resistances and capacitances,

(b) a means for deriving a closed circuit of said equivalent circuit,

(c) a transforming means for subjecting said closed circuit equation to s - z transformation and for thereby providing an equation projected on a z-plane, and

(d) a means for providing said equation projected on the z-plane as an equation providing a closed circuit current and having delay, said adder means (2), multiplier means (3), and delay means (4) being determined in combination by said equation providing the closed circuit current and having the delay.

11. A digital filter according to claim 10 wherein said closed circuit equation is given as

$$\begin{pmatrix} E \\ 0 \\ \vdots \\ 0 \end{pmatrix} = [R_{ij} + \frac{1}{sC_{ij}}] \begin{pmatrix} I_1 \\ I_2 \\ \vdots \\ I_n \end{pmatrix} \qquad (i,j = 1,2..., n)$$

where E is electromotive force, $R_{ij}$, resistance , $C_{ij}$ capacitance, $I_i$ a closed circuit current, and s a complex variable of a transfer function $H_A(s)$ of the analog filter.

12. A digital filter according to claim 11 wherein siad s - z transformation is given as

$$s = \frac{2}{T}\,\frac{1 - z^{-1}}{1 + z^{-1}}$$

where s is a complex variable of the transfer function $H_A(s)$ of the analog filter, z a complex variable of a transfer function $H_D(z)$ of the digital filter, and T a sampling interval.

Fig. 1

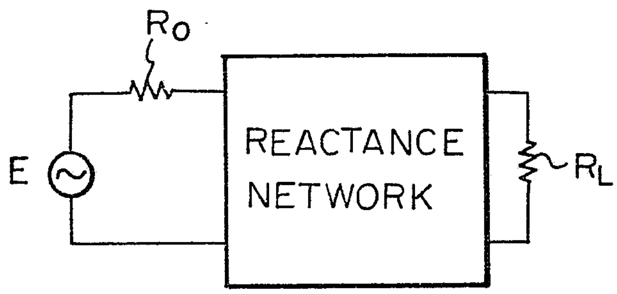

Ro
E
REACTANCE
NETWORK
RL


Fig. 2

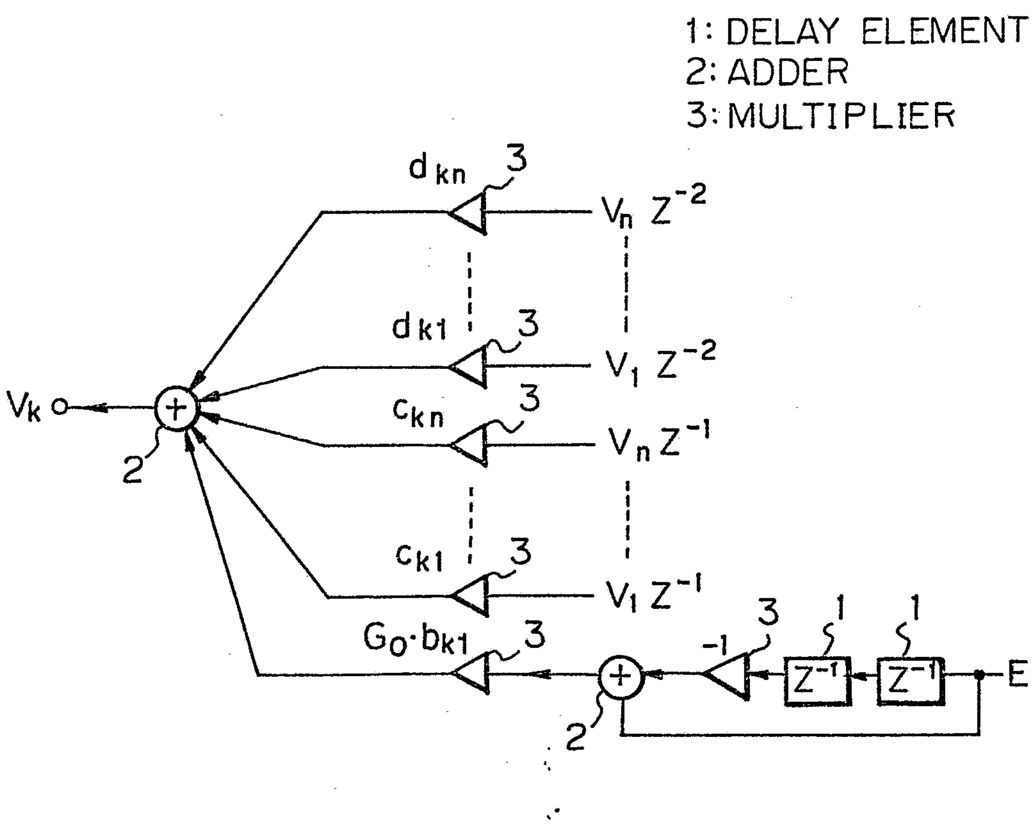

1: DELAY ELEMENT
2: ADDER
3: MULTIPLIER
dkn
Vn Z-2
dk1
V1 Z-2
ckn
Vn Z-1
ck1
V1 Z-1
Go·bk1
Vk
-1
Z-1
E

Fig. 3

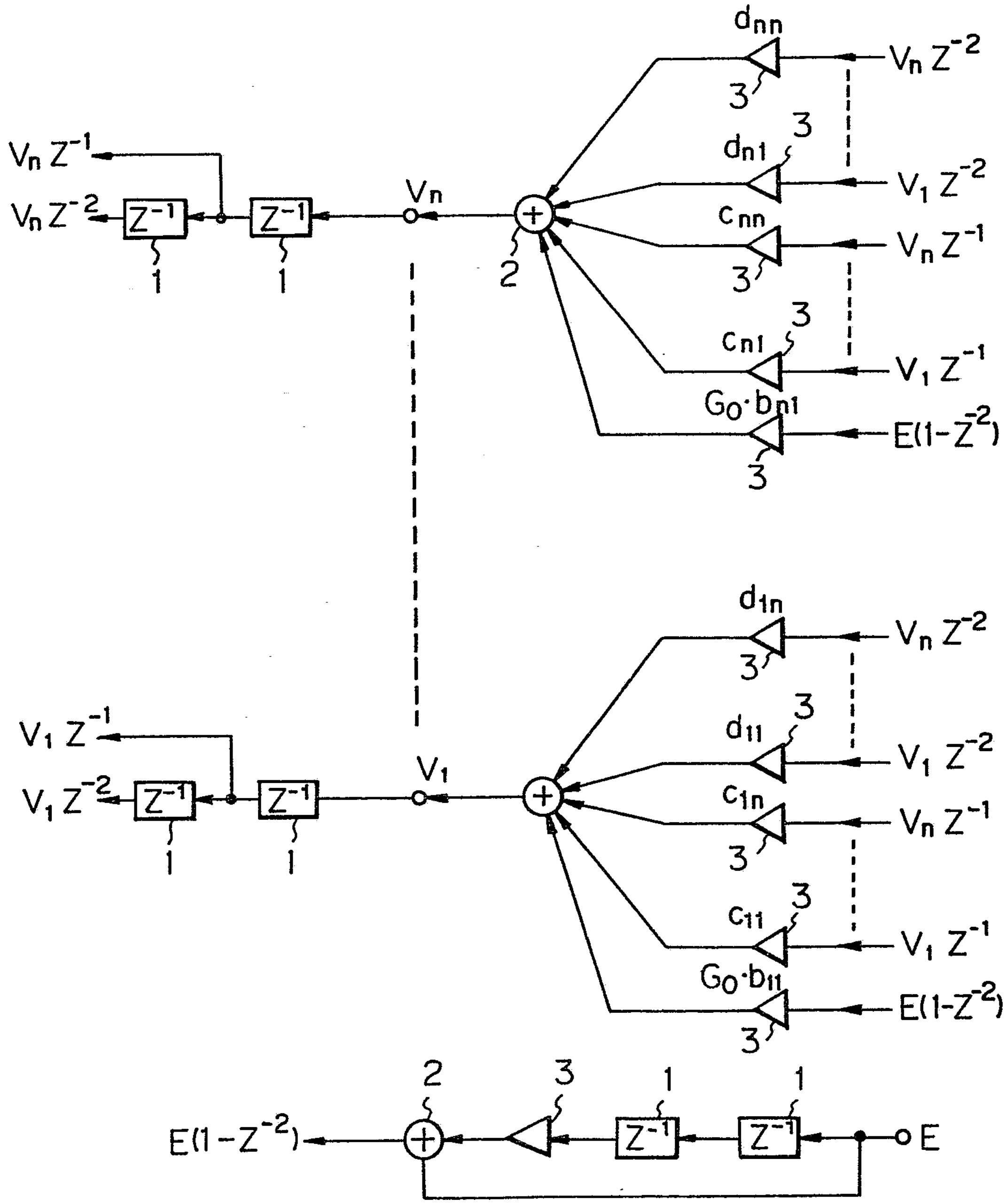


1: DELAY ELEMENT
2: ADDER
3: MULTIPLIER

# Fig. 4

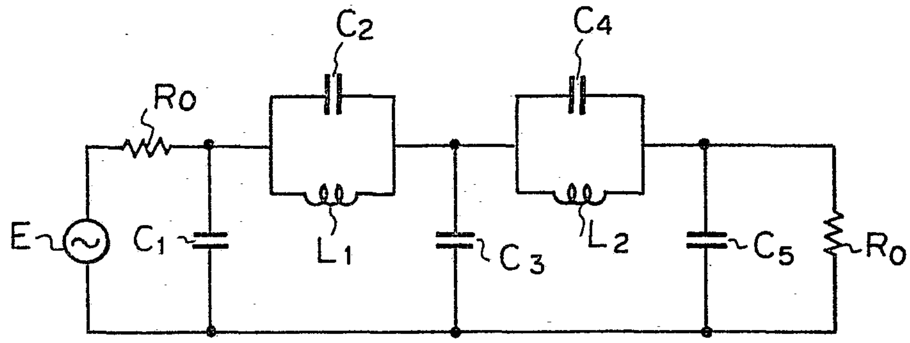


$C_1$ = 0.15573952 (nF)
$C_2$ = 0.10799933 (nF)
$C_3$ = 0.27882376 (nF)
$C_4$ = 0.036408855 (nF)
$C_5$ = 0.20290253 (nF)
$L_1$ = 0.12508277 (mH)
$L_2$ = 0.17601310 (mH)
$R_0$ = 1.0 (kΩ)

# Fig. 5

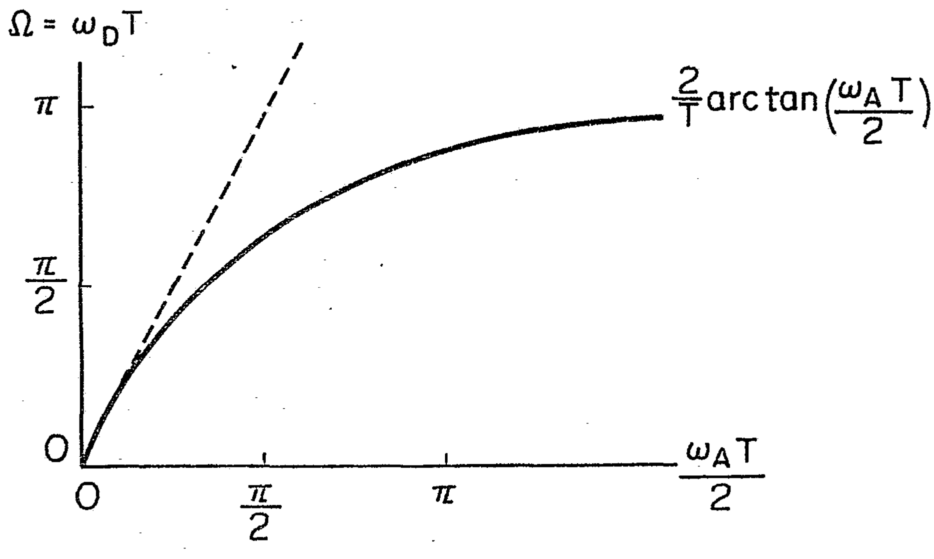

Fig. 6

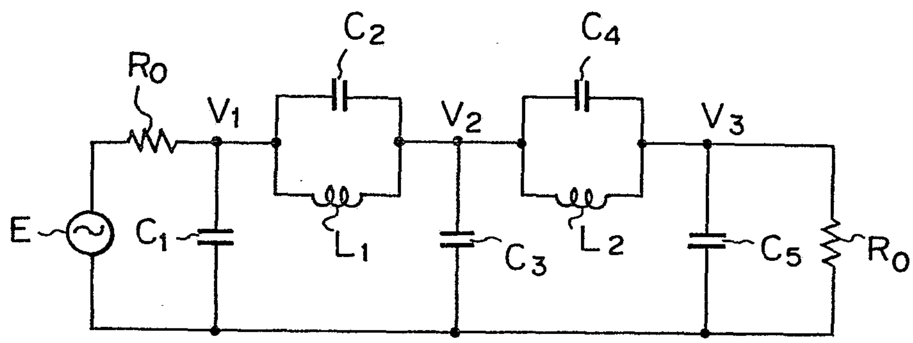


$C_1$=0.15058186 (nF)
$C_2$=0.10442269 (nF)
$C_3$=0.26958990 (nF)
$C_4$=0.035203095 (nF)
$C_5$=0.19618297 (nF)

$L_1$=0.12094038 (mH)
$L_2$=0.17018404 (mH)
$R_0$=1.0 (kΩ)

## Fig. 7

| i | $b_{i,1}$ |
|---|---|
| 1 | 172.53353 |
| 2 | 49.482887 |
| 3 | 8.3385787 |

| i \ j | $C_{ij}$ 1 | 2 | 3 |
|---|---|---|---|
| 1 | 1.4514432 | 0.15513705 | 0.031675565 |
| 2 | 0.032244775 | 1.7429056 | 0.082465708 |
| 3 | 0.0054337088 | 0.15513815 | 1.4776833 |

| i \ j | $d_{ij}$ 1 | 2 | 3 |
|---|---|---|---|
| 1 | -0.65493293 | 0.00000000 | 0.016677157 |
| 2 | 0.098965773 | -1.00000000 | 0.043418122 |
| 3 | 0.016677157 | 0.00000000 | -0.65493235 |

Fig. 8

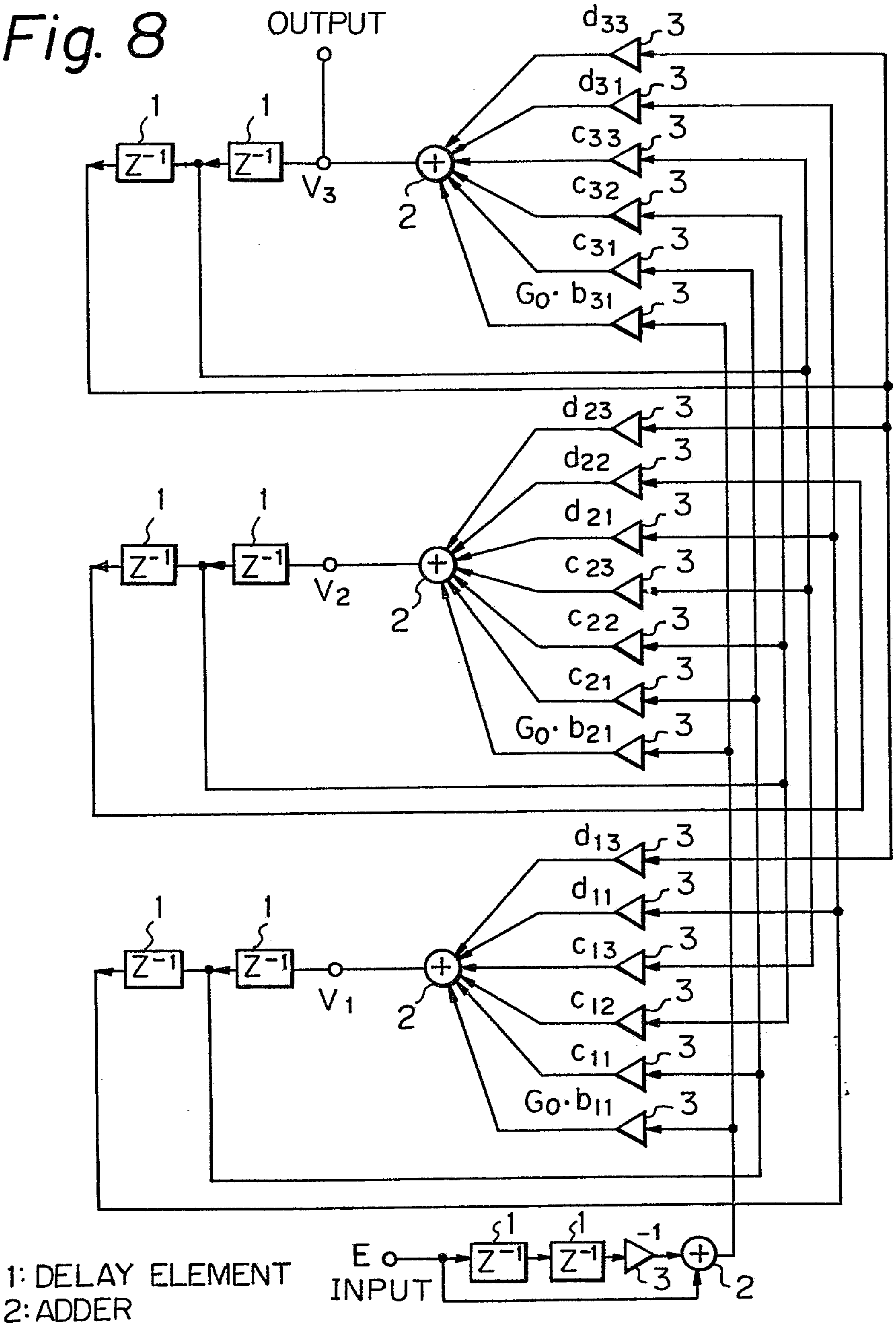


1: DELAY ELEMENT
2: ADDER
3: MULTIPLIER

Fig. 9

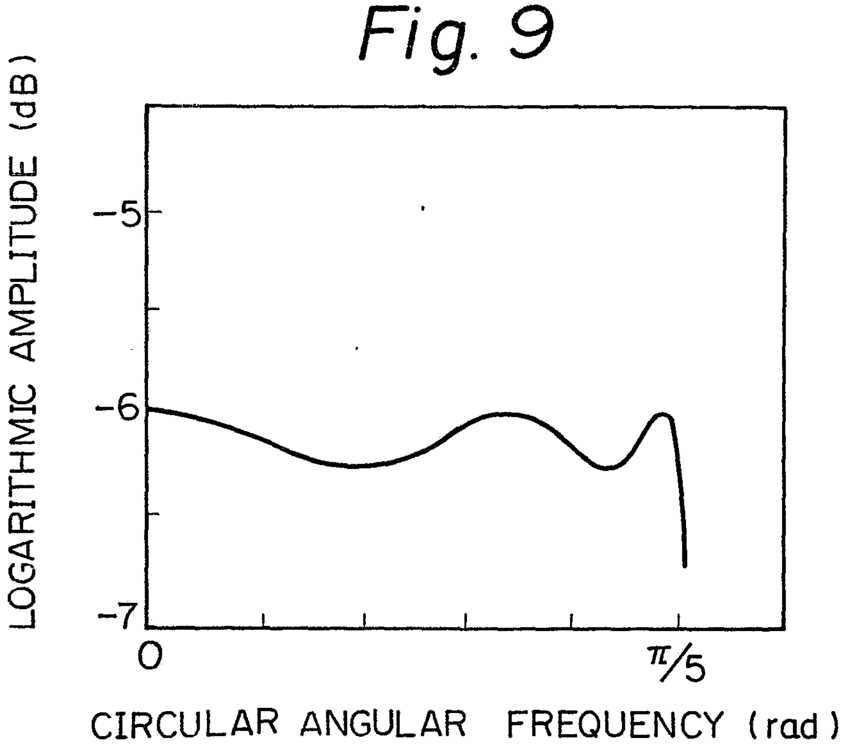
LOGARITHMIC AMPLITUDE (dB)
-5
-6
-7
0
π/5
CIRCULAR ANGULAR FREQUENCY (rad)

Fig. 10

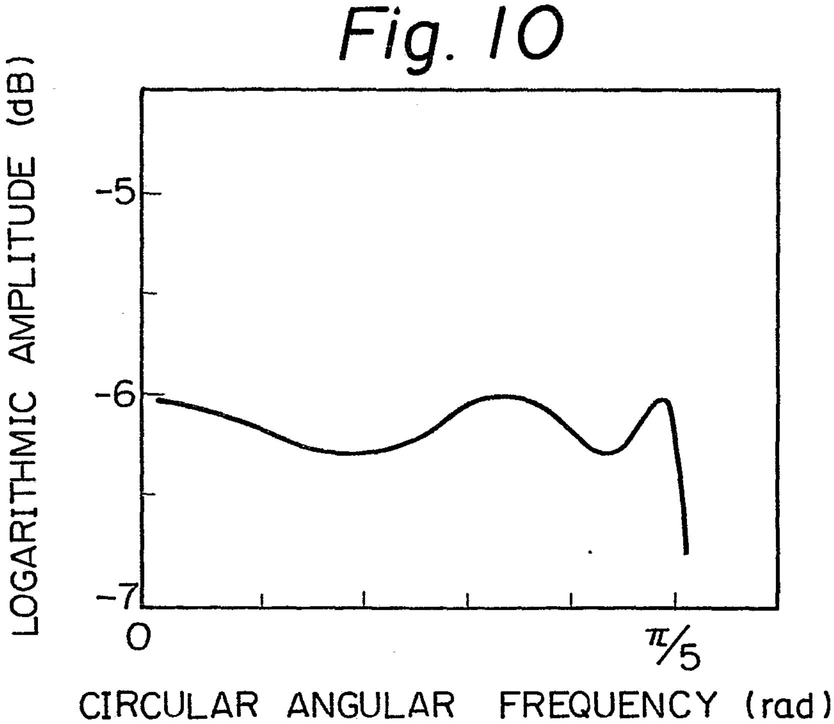
LOGARITHMIC AMPLITUDE (dB)
-5
-6
-7
0
π/5
CIRCULAR ANGULAR FREQUENCY (rad)

0194318

Fig. 11

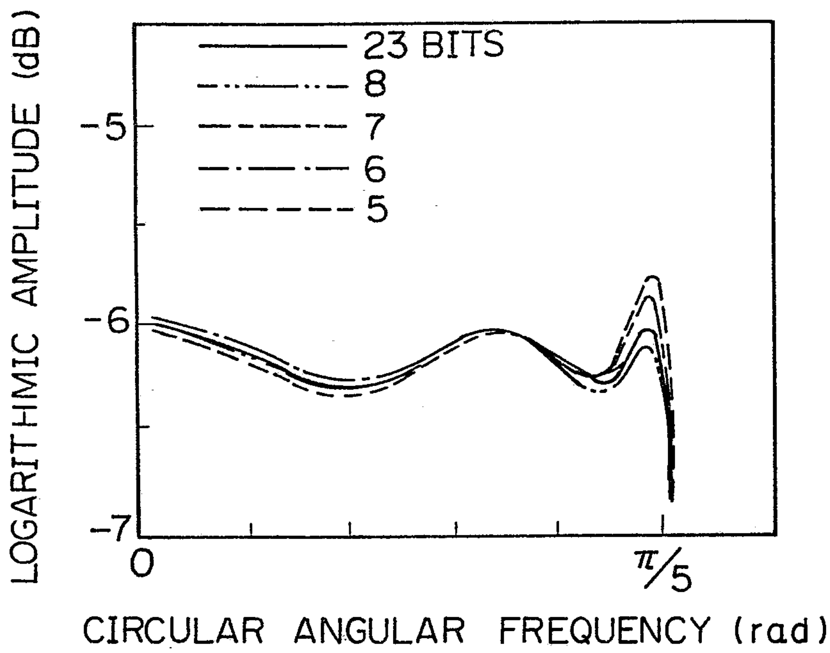


Fig. 13

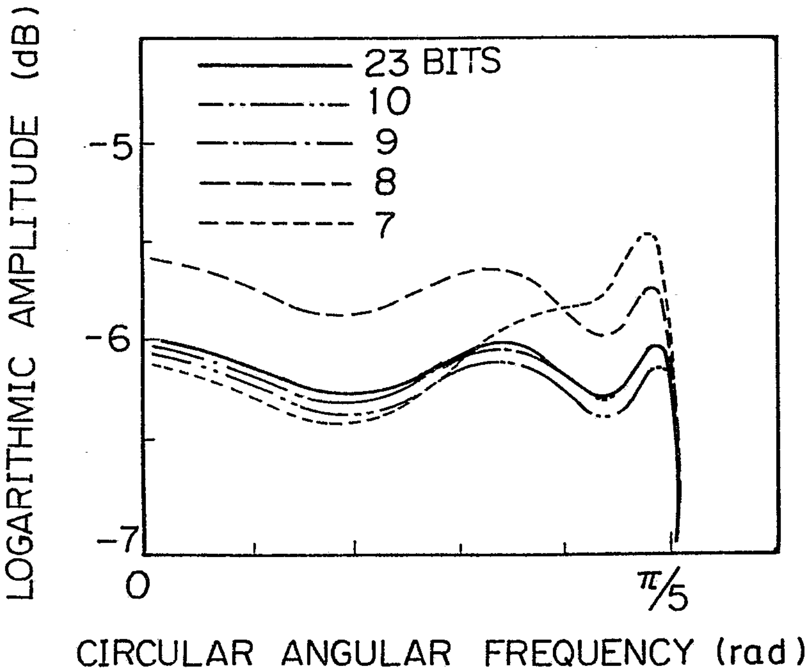

Fig. 12

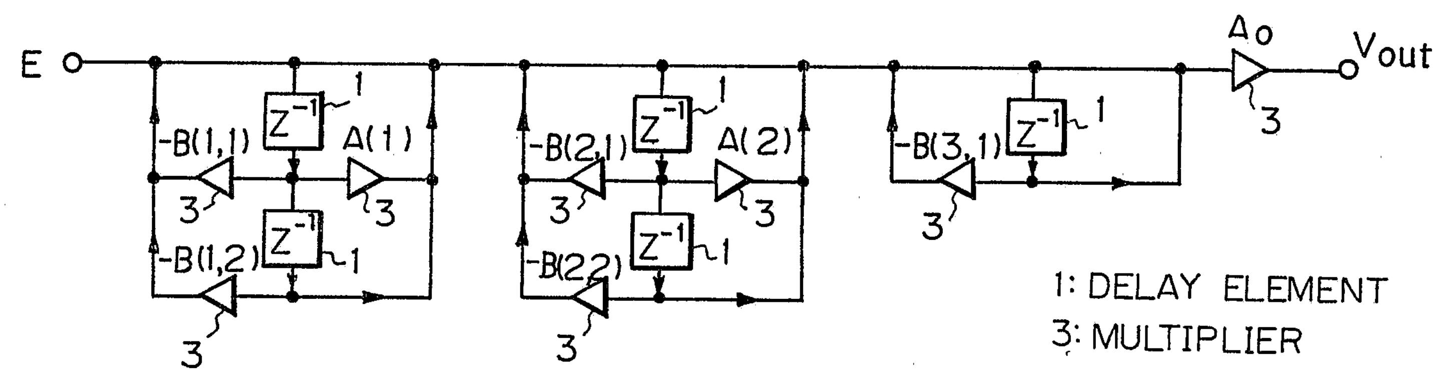


A(1) = −1.3390091
A(2) = −0.82228309
$A_0$ = 0.008338547

B(1,1) = −1.5246771
B(1,2) = 0.91004454
B(2,1) = −1.4460079
B(2,2) = 0.67160943
B(3,1) = −0.70134506

# Fig. 14

| COEFFICIENT | OPERATION | FILTER BY FIRST EMBODIMENT OF THE PRESENT INVENTION | | CONVENTIONAL CASCADE FILTER | |
|---|---|---|---|---|---|
| WORD LENGTH | WORD LENGTH | RIPPLE WIDTH (dB) | RELATIE ERROR (dB) | RIPPLE WIDTH (dB) | RELATIVE ERROR (dB) |
| 12 | 12 | 0.285 | 0.0108 | 0.305 | 0.0135 |
| 10 | 12 | 0.279 | 0.0181 | 0.371 | 0.0351 |
| | 11 | 0.295 | 0.0240 | 0.371 | 0.0308 |
| | 10 | 0.321 | 0.0348 | 0.358 | 0.0266 |
| 8 | 12 | 0.294 | 0.0173 | 0.308 | 0.0231 |
| | 11 | 0.275 | 0.0188 | 0.305 | 0.0233 |
| | 10 | 0.356 | 0.0254 | 0.355 | 0.0795 |
| | 9 | 0.338 | 0.0574 | 0.458 | 0.0705 |
| | 8 | 0.374 | 0.0759 | 0.468 | 0.1491 |
| 6 | 12 | 0.315 | 0.0589 | 0.958 | 0.2139 |
| | 11 | 0.286 | 0.0671 | 0.975 | 0.2079 |
| | 10 | 0.291 | 0.0974 | 0.946 | 0.2037 |
| | 9 | 0.301 | 0.1353 | 0.987 | 0.1805 |
| | 8 | 0.393 | 0.2154 | 1.183 | 0.3239 |
| | 7 | 0.380 | 0.2712 | 0.891 | 0.2326 |

Fig. 15

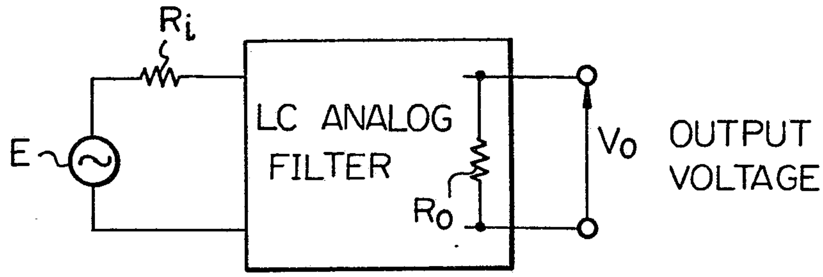


Fig. 16

1: DELAY ELEMENT
2: ADDER
3: MULTIPLIER

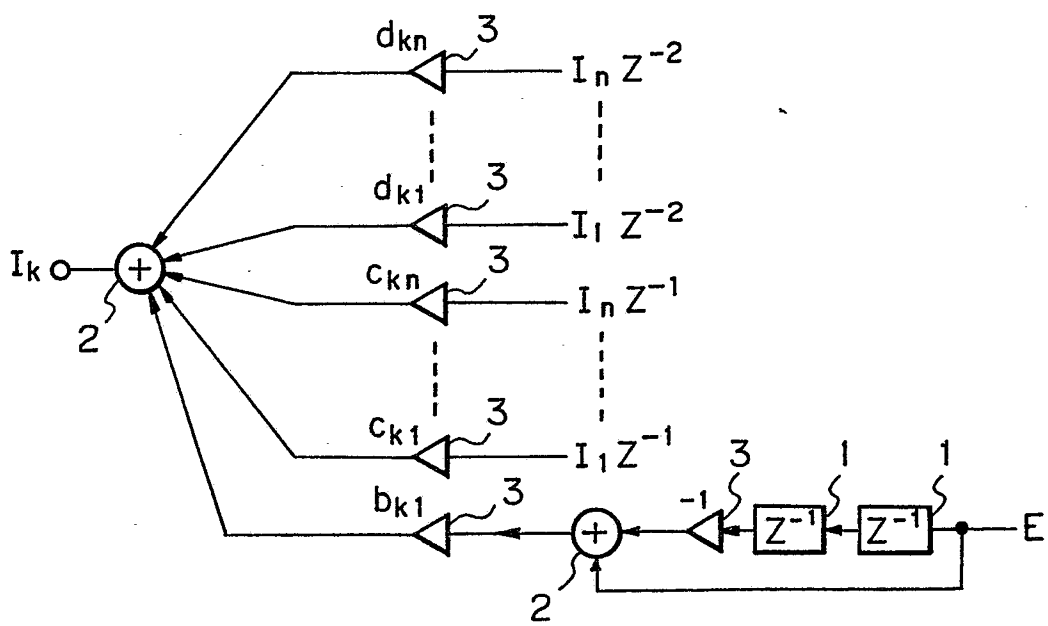

0194318

Fig. 17

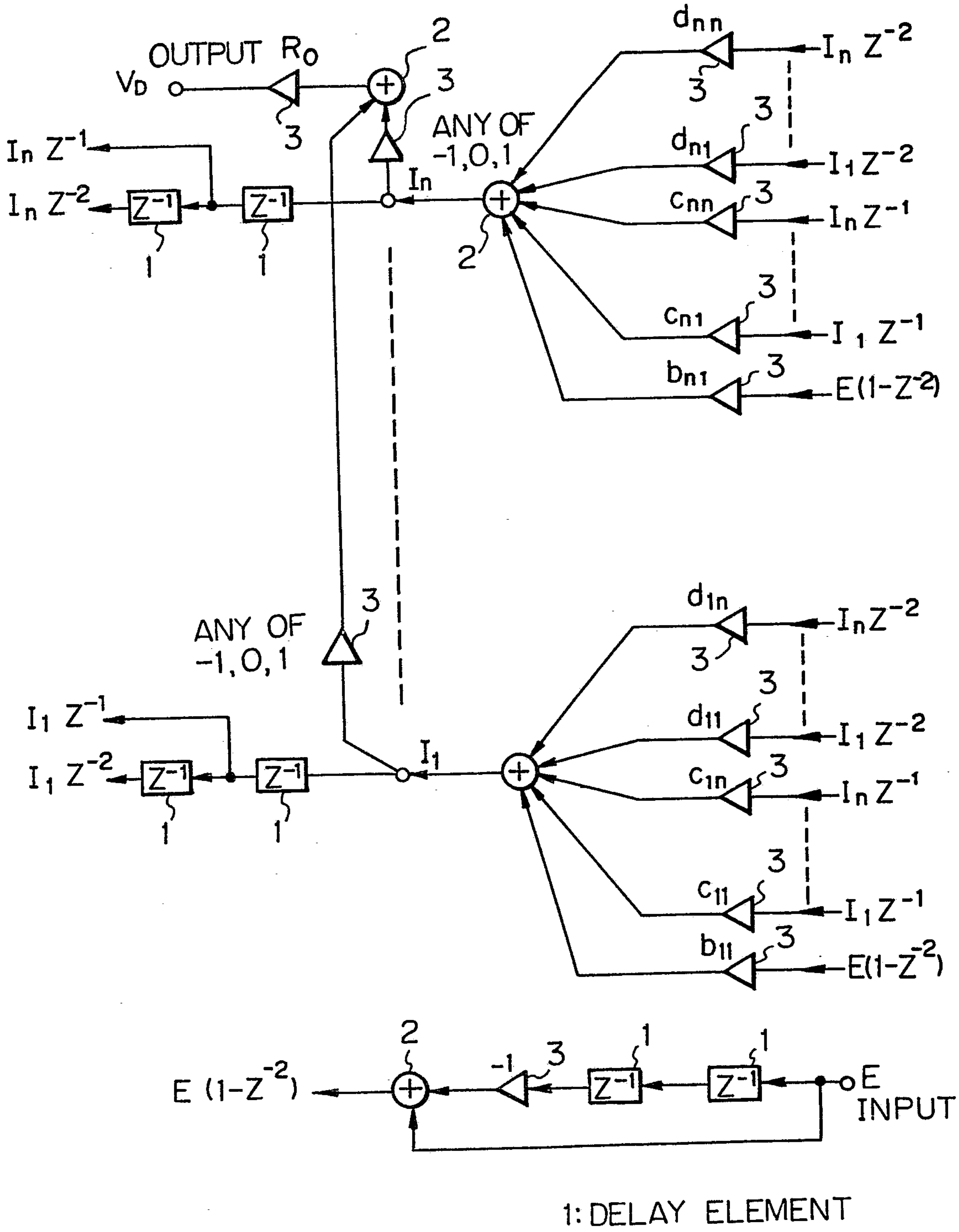


1: DELAY ELEMENT
2: ADDER
3: MULTIPLIER

Fig. 18

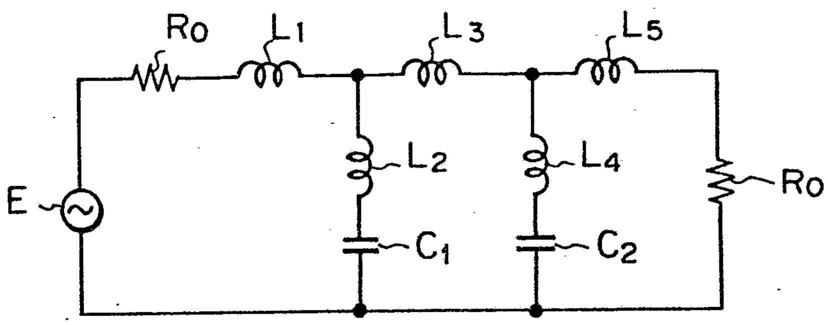


$L_1$ = 0.15573952 (nH)
$L_2$ = 0.10799933 (nH)
$L_3$ = 0.27882376 (nH)
$L_4$ = 0.036408855 (nH)
$L_5$ = 0.20290253 (nH)

$C_1$ = 0.12508277 (mF)
$C_2$ = 0.17601310 (mF)

$R_0$ = 1.0 (mΩ)

Fig. 19

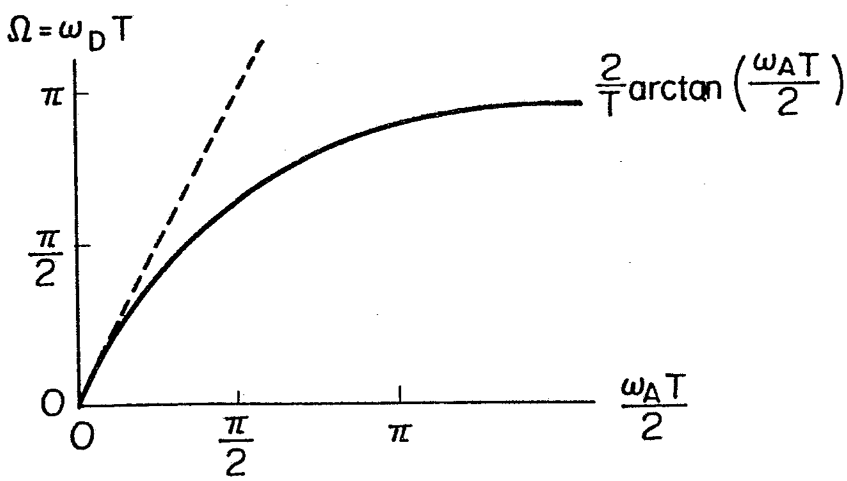

*Fig. 20*

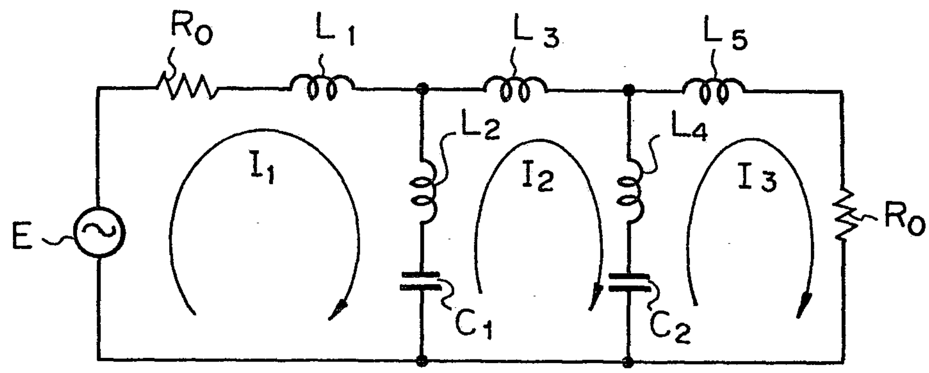


$L_1$ = 0.15058186 (nH)

$L_2$ = 0.10442269 (nH)

$L_3$ = 0.26958990 (nH)

$L_4$ = 0.035203095 (nH)

$L_5$ = 0.19618297 (nH)

$C_1$ = 0.12094038 (mF)

$C_2$ = 0.17018404 (mF)

$R_0$ = 1.0 (mΩ)

# Fig. 21

| i | $b_{i,1}$ |
|---|---|
| 1 | 172.53353 |
| 2 | 49.482887 |
| 3 | 8.3385787 |

| i \ j | $c_{ij}$ 1 | 2 | 3 |
|---|---|---|---|
| 1 | 1.4514432 | 0.15513705 | 0.031675565 |
| 2 | 0.032244775 | 1.7429056 | 0.082465708 |
| 3 | 0.0054337088 | 0.15513815 | 1.4776833 |

| i \ j | $d_{ij}$ 1 | 2 | 3 |
|---|---|---|---|
| 1 | -0.65493293 | 0.00000000 | 0.016677157 |
| 2 | 0.098965773 | -1.00000000 | 0.043418122 |
| 3 | 0.016677157 | 0.00000000 | -0.65493235 |

Fig. 22

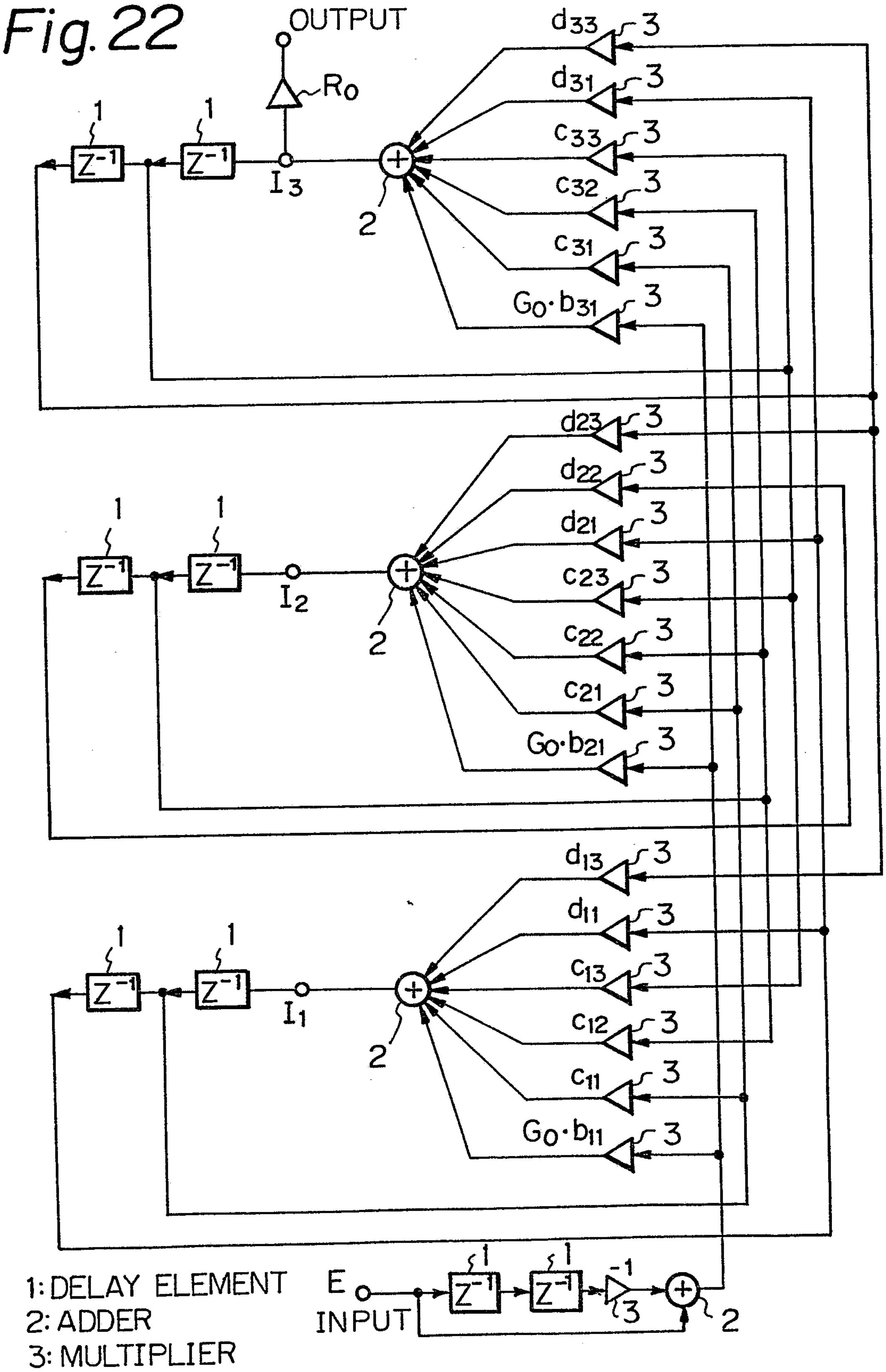


1: DELAY ELEMENT
2: ADDER
3: MULTIPLIER

Fig. 23

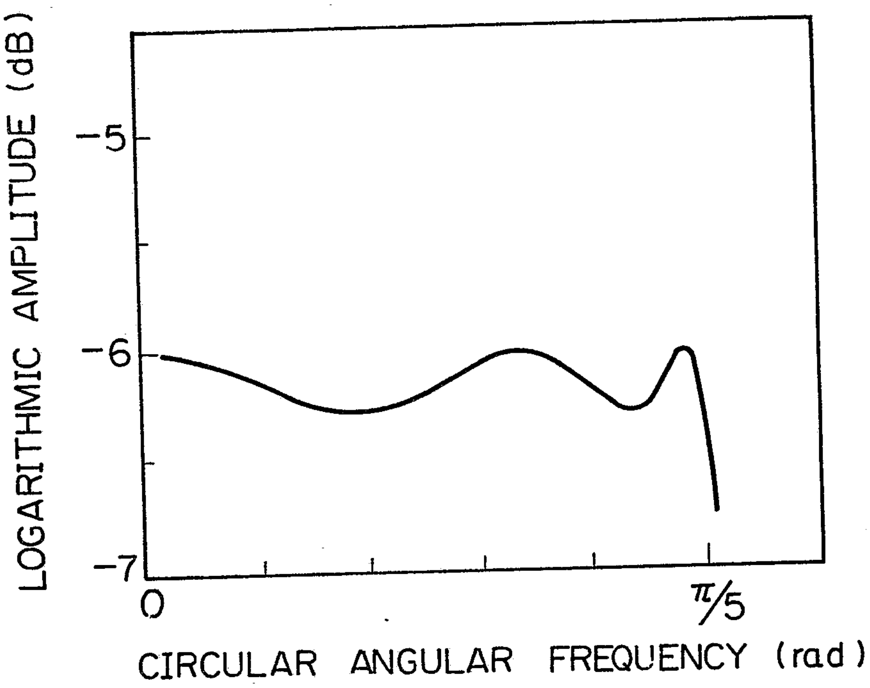
LOGARITHMIC AMPLITUDE (dB)
-5
-6
-7
0
π/5
CIRCULAR ANGULAR FREQUENCY (rad)

Fig. 24

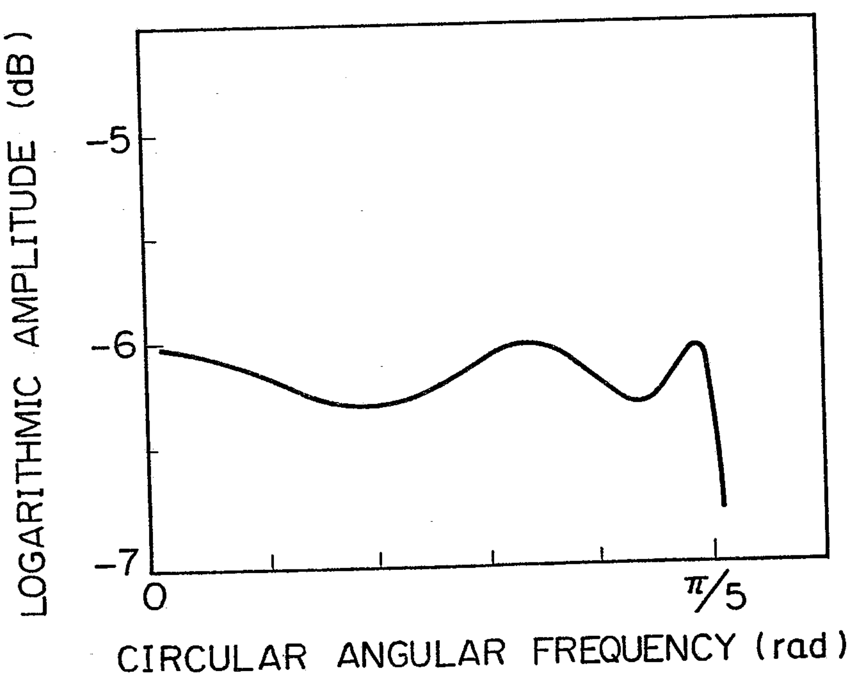
LOGARITHMIC AMPLITUDE (dB)
-5
-6
-7
0
π/5
CIRCULAR ANGULAR FREQUENCY (rad)

Fig. 25

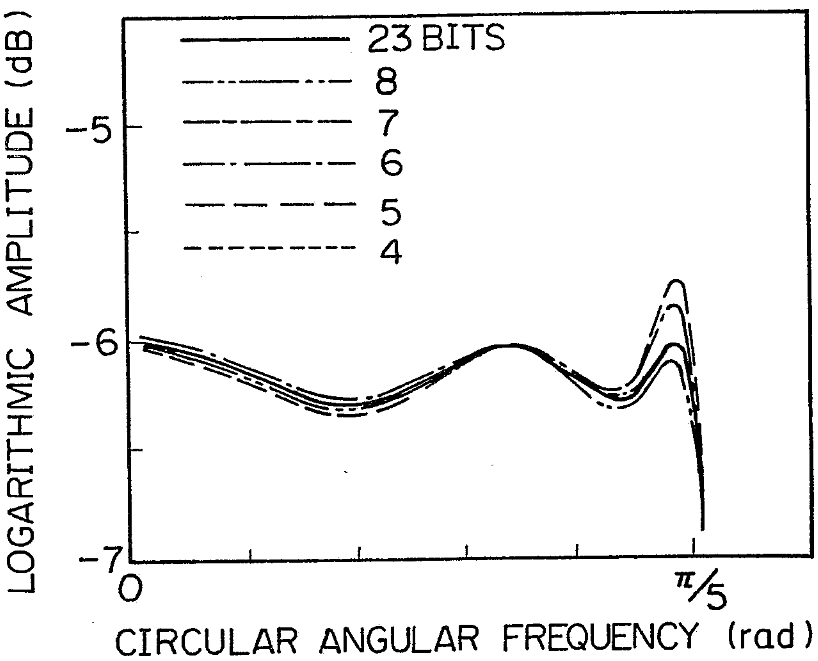
23 BITS
8
7
6
5
4
-5
-6
-7
LOGARITHMIC AMPLITUDE (dB)
0
π/5
CIRCULAR ANGULAR FREQUENCY (rad)

Fig. 27

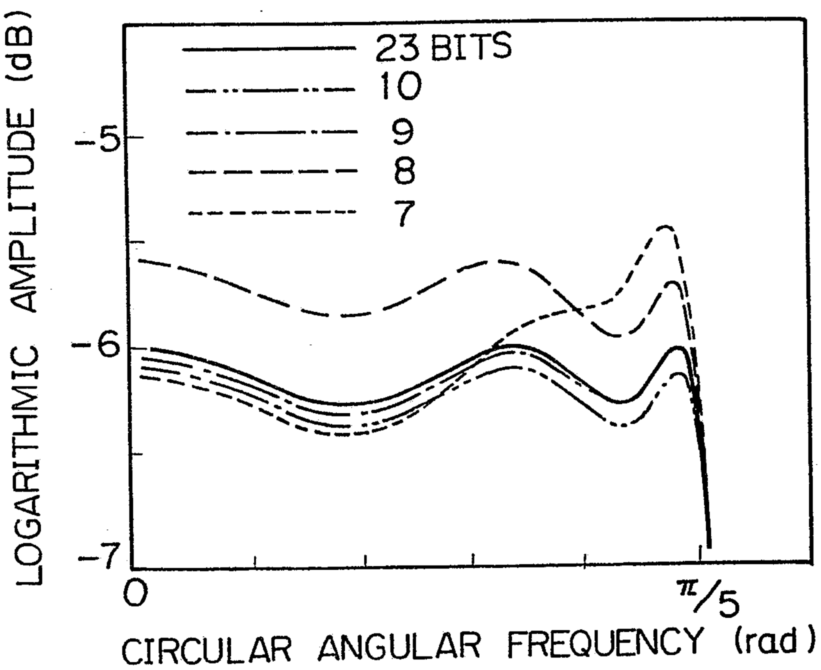
23 BITS
10
9
8
7
-5
-6
-7
LOGARITHMIC AMPLITUDE (dB)
0
π/5
CIRCULAR ANGULAR FREQUENCY (rad)

Fig. 26

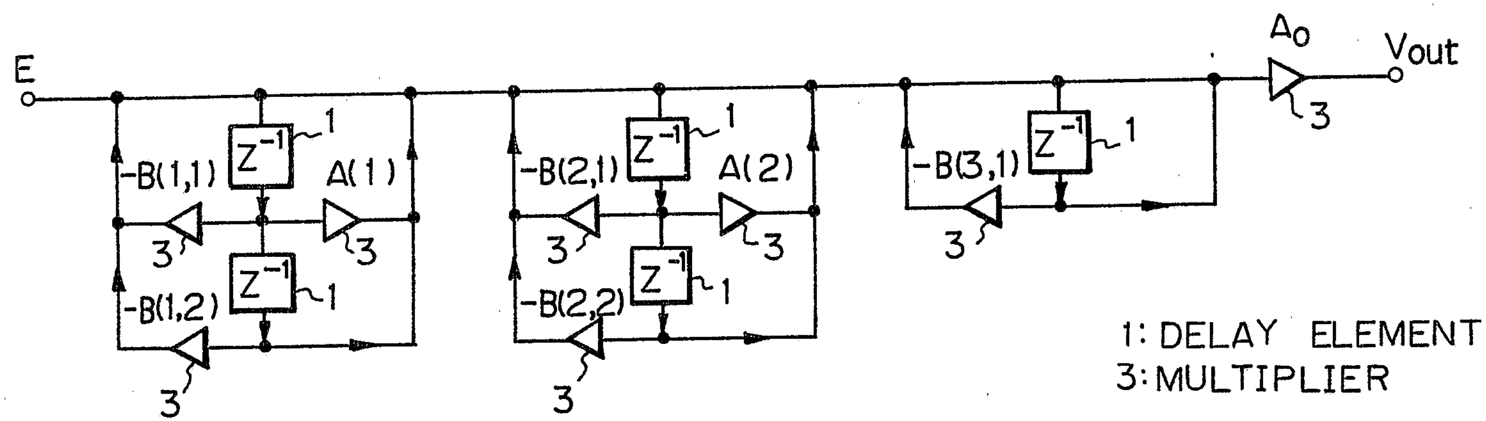


A(1) = −1.3390091
A(2) = −0.82228309
$A_0$ = 0.008338547

B(1,1) = −1.5246771
B(1,2) = 0.91004454
B(2,1) = −1.4460079
B(2,2) = 0.67160943
B(3,1) = −0.70134506

Fig. 28

| COEFFICIENT | OPERATION | FILTER BY SECOND EMBODIMENT OF THE PRESENT INVENTION | | CONVENTIONAL CASCADE FILTER | |
|---|---|---|---|---|---|
| WORD LENGTH | WORD LENGTH | RIPPLE WIDTH (dB) | RELATIVE WIDTH (dB) | RIPPLE WIDTH (dB) | RELATIVE WIDTH (dB) |
| 12 | 12 | 0.285 | 0.0108 | 0.305 | 0.0135 |
| 10 | 12 | 0.279 | 0.0181 | 0.371 | 0.0351 |
| | 11 | 0.295 | 0.0240 | 0.371 | 0.0308 |
| | 10 | 0.321 | 0.0348 | 0.358 | 0.0266 |
| 8 | 12 | 0.294 | 0.0173 | 0.308 | 0.0231 |
| | 11 | 0.275 | 0.0188 | 0.305 | 0.0233 |
| | 10 | 0.356 | 0.0254 | 0.355 | 0.0795 |
| | 9 | 0.338 | 0.0574 | 0.458 | 0.0705 |
| | 8 | 0.374 | 0.0759 | 0.468 | 0.1491 |
| 6 | 12 | 0.315 | 0.0589 | 0.958 | 0.2139 |
| | 11 | 0.286 | 0.0671 | 0.975 | 0.2079 |
| | 10 | 0.291 | 0.0974 | 0.946 | 0.2037 |
| | 9 | 0.301 | 0.1353 | 0.987 | 0.1805 |
| | 8 | 0.393 | 0.2154 | 1.183 | 0.3239 |
| | 7 | 0.380 | 02712 | 0.891 | 0.2326 |

Fig. 29(a)

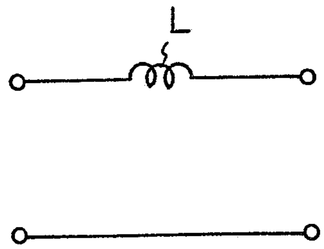


Fig. 29(b)

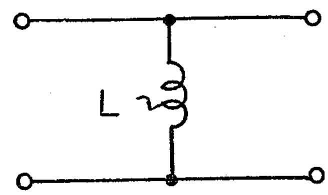


Fig. 29(c)

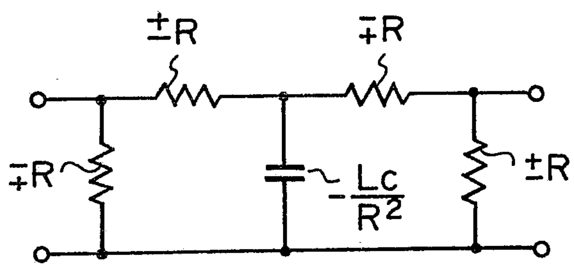


Fig. 29(d)

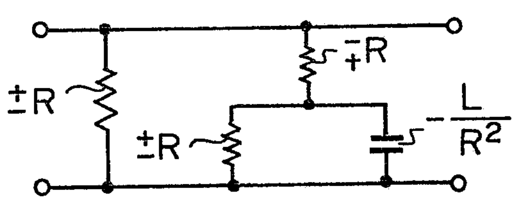


L: INDUCTANCE
R: RESISTANCE

Fig. 30

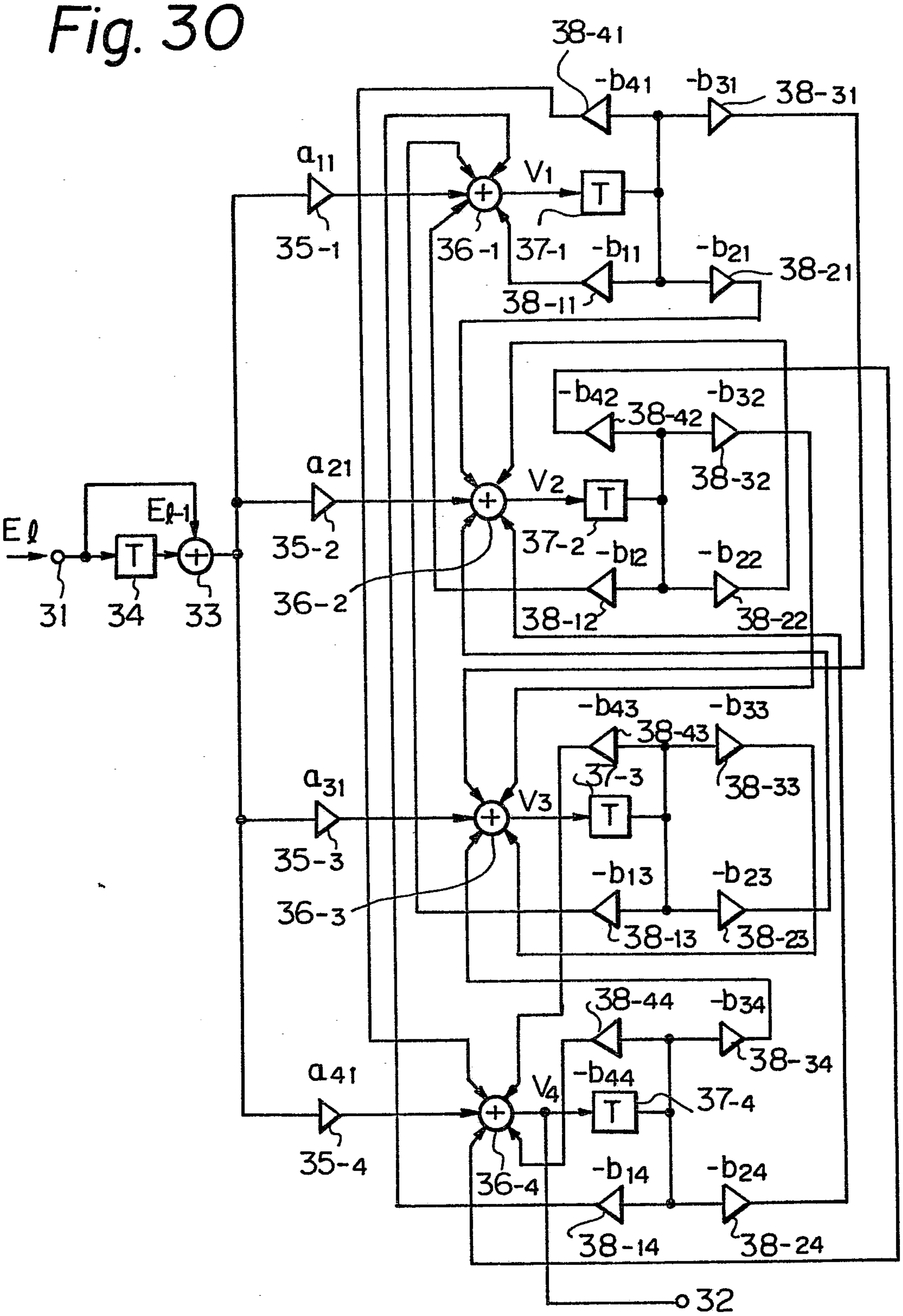

38-41
$-b_{41}$
$-b_{31}$
38-31
$a_{11}$
$V_1$
T
35-1
36-1
37-1
$-b_{11}$
$-b_{21}$
38-21
38-11
$-b_{42}$
38-42
$-b_{32}$
38-32
$a_{21}$
$V_2$
T
$E_\ell$
$E_{\ell-1}$
T
35-2
37-2
$-b_{12}$
$-b_{22}$
31
34
33
36-2
38-12
38-22
$-b_{43}$
38-43
$-b_{33}$
37-3
38-33
$a_{31}$
$V_3$
T
35-3
$-b_{13}$
$-b_{23}$
36-3
38-13
38-23
38-44
$-b_{34}$
38-34
$a_{41}$
$-b_{44}$
$V_4$
T
37-4
35-4
36-4
$-b_{14}$
$-b_{24}$
38-14
38-24
32

0194318

Fig. 31

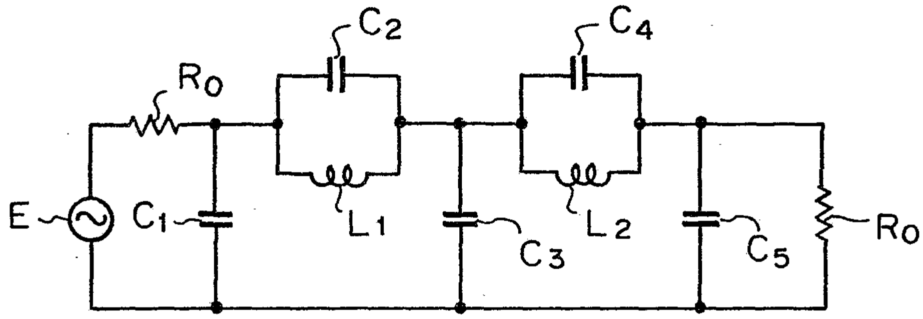


CAPACITANCE 1 : $C_1$=0.15573952(nF) INDUCTANCE1 : $L_1$=0.12508277(mH)
CAPACITANCE2 : $C_2$=0.10799933(nF) INDUCTANCE2 : $L_2$=0.17601310(mH)
CAPACITANCE3 : $C_3$=0.27882376(nF) RESISTANCE0 : $R_0$= 1.0 (KΩ)
CAPACITANCE4 : $C_4$=0.036408855(nF)
CAPACITANCE5 : $C_5$=0.20290253(nF)

Fig. 33

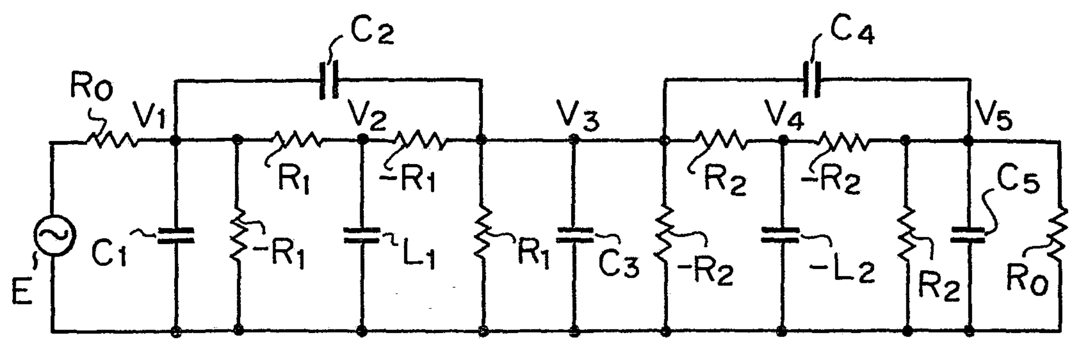


CAPACITANCE1:$C_1$=0.15058186(nF) INDUCTANCE1:$L_1$=0.12094037(mH)
CAPACITANCE2:$C_2$=0.10442172(nF) INDUCTANCE2:$L_2$=0.17018404(mH)
CAPACITANCE3:$C_3$=0.26958990(nF) RESISTANCE :$R_0$=$R_1$=$R_2$=1(KΩ)
CAPACITANCE4:$C_4$=0.035203095(nF)
CAPACITANCE5:$C_5$=0.19618296(nF)

*Fig. 32*

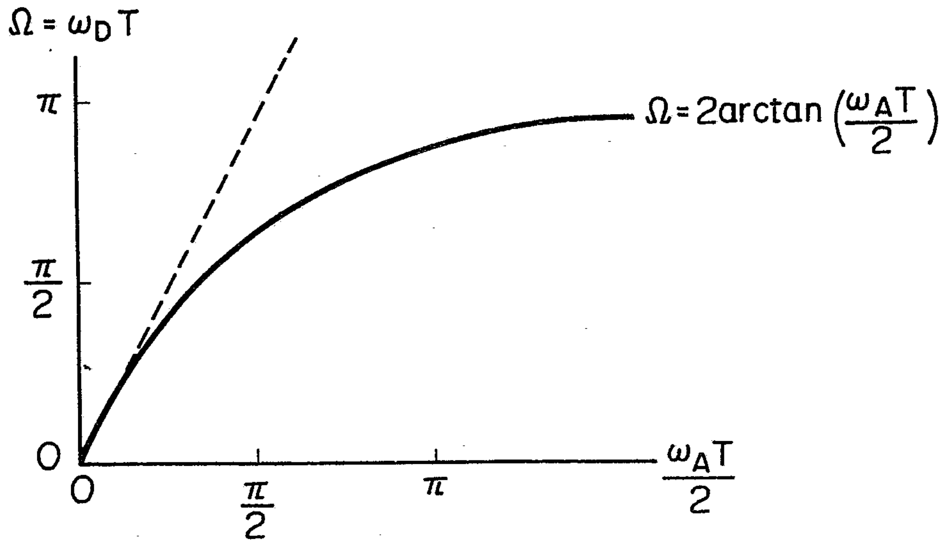

Fig. 34

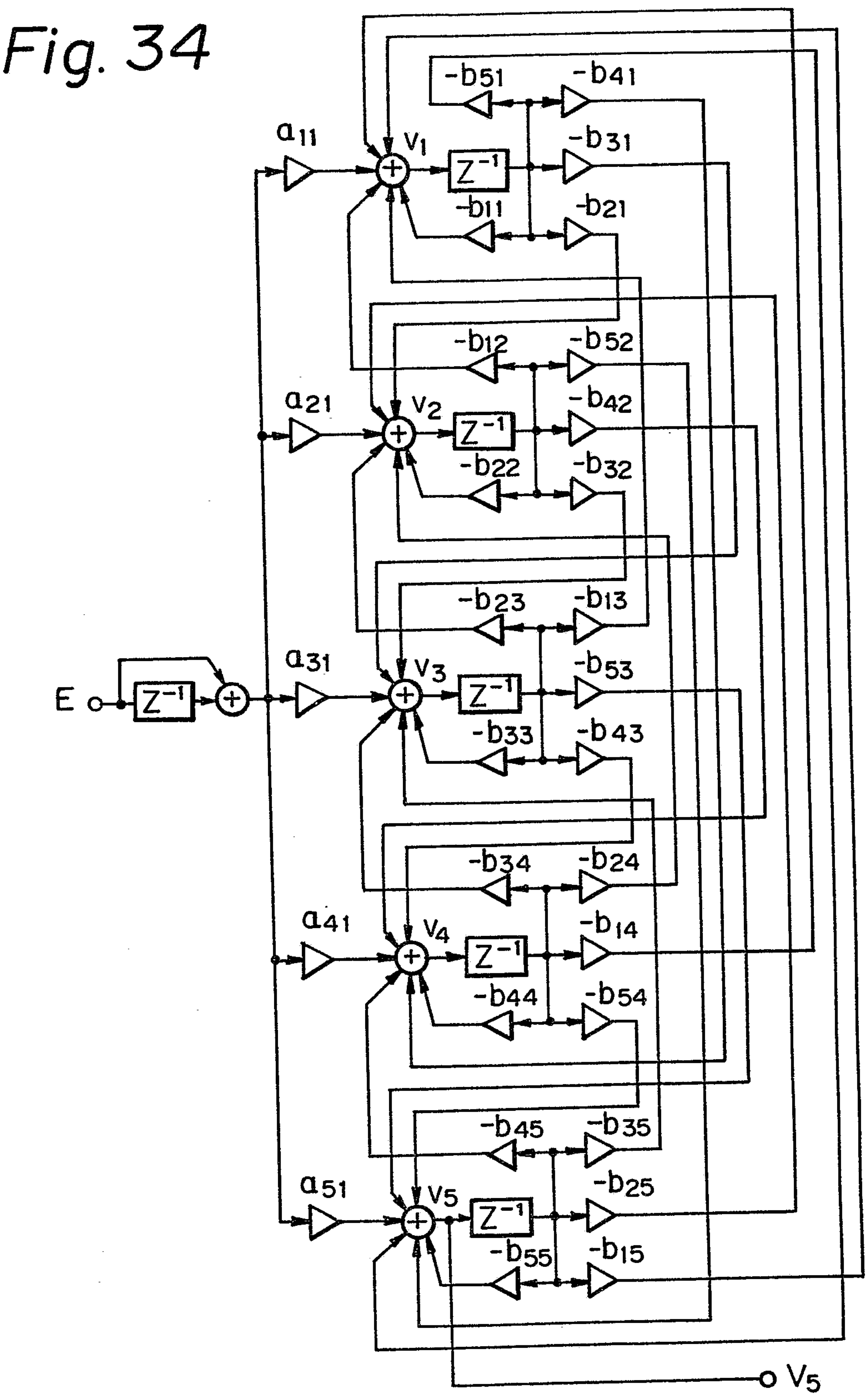
E
V5
a11
a21
a31
a41
a51
V1
V2
V3
V4
V5
$Z^{-1}$
-b11 -b21 -b31 -b41 -b51
-b12 -b22 -b32 -b42 -b52
-b13 -b23 -b33 -b43 -b53
-b14 -b24 -b34 -b44 -b54
-b15 -b25 -b35 -b45 -b55

Fig. 35

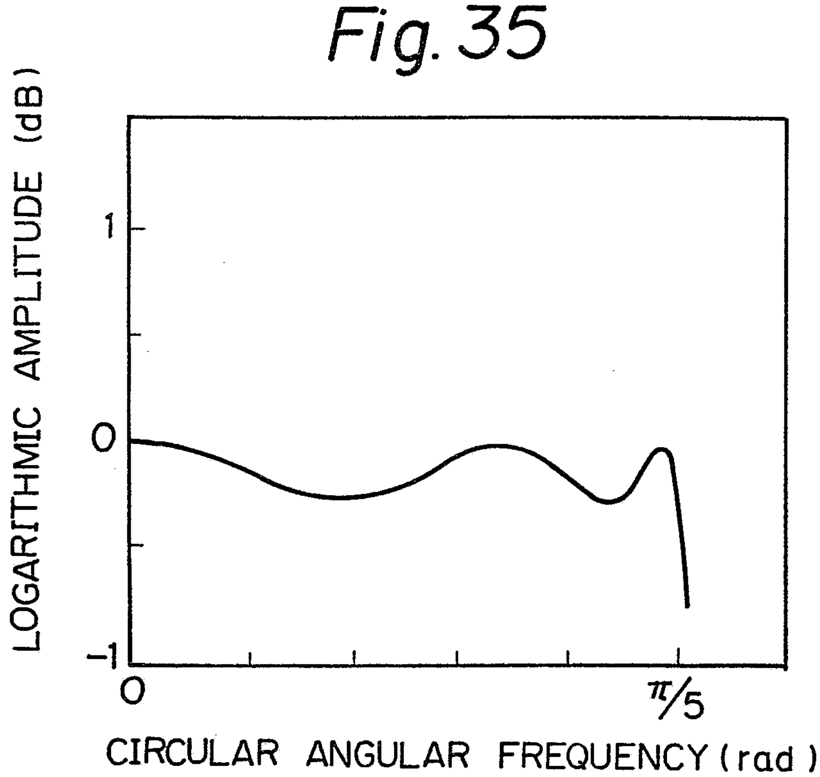
LOGARITHMIC AMPLITUDE (dB)
1
0
-1
0
π/5
CIRCULAR ANGULAR FREQUENCY (rad)

Fig. 36

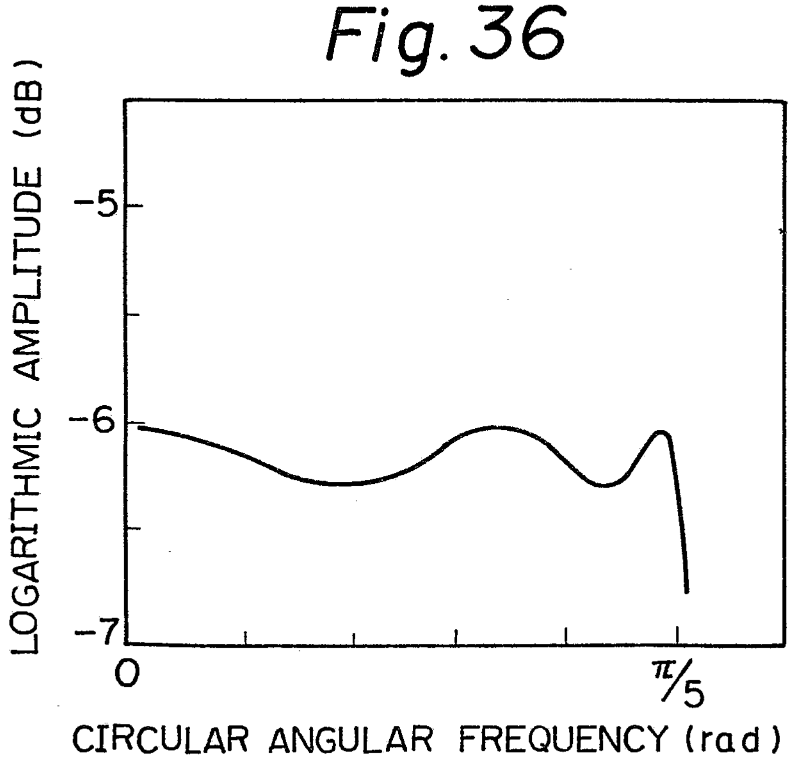
LOGARITHMIC AMPLITUDE (dB)
-5
-6
-7
0
π/5
CIRCULAR ANGULAR FREQUENCY (rad)

0194318

# Fig. 37

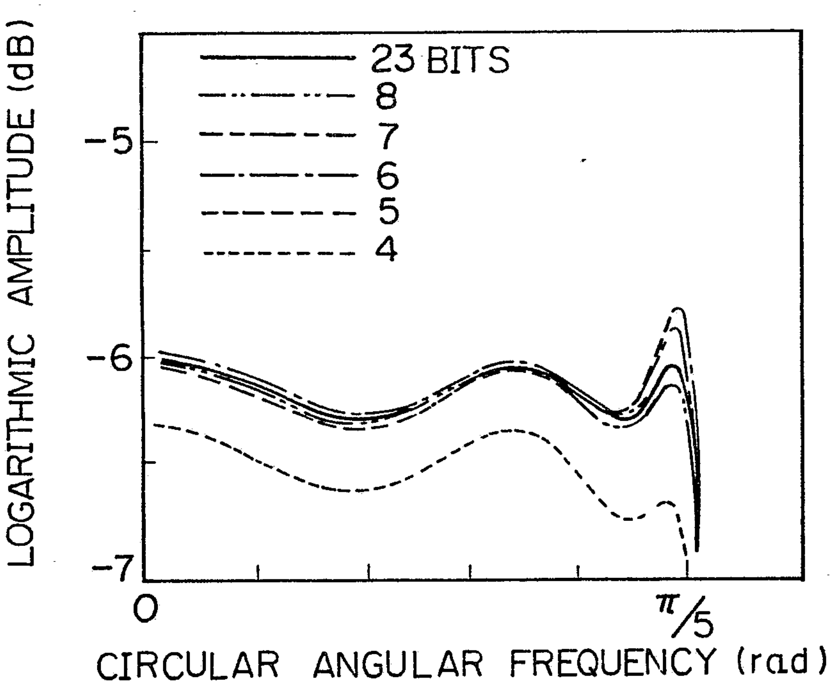


# Fig. 39

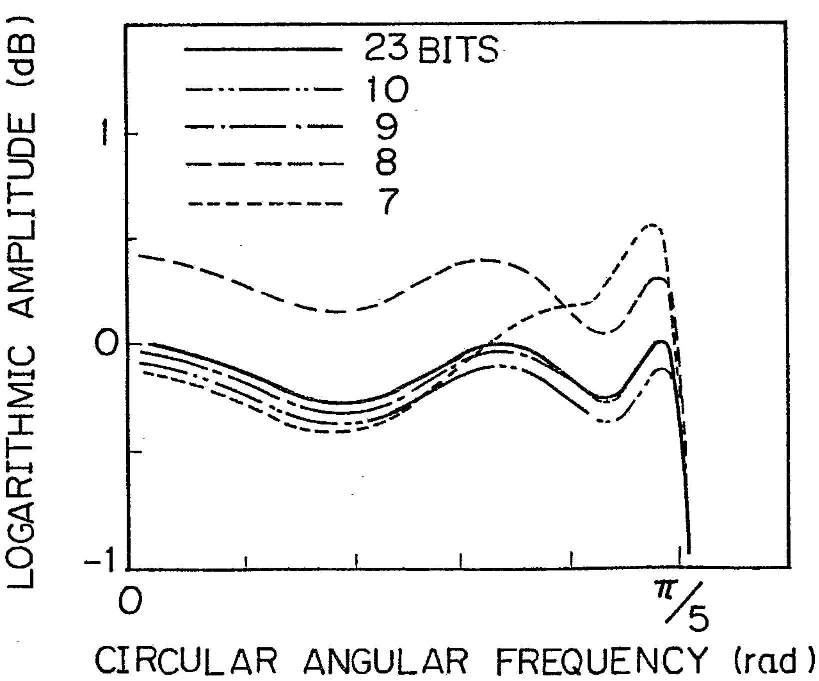

Fig. 38

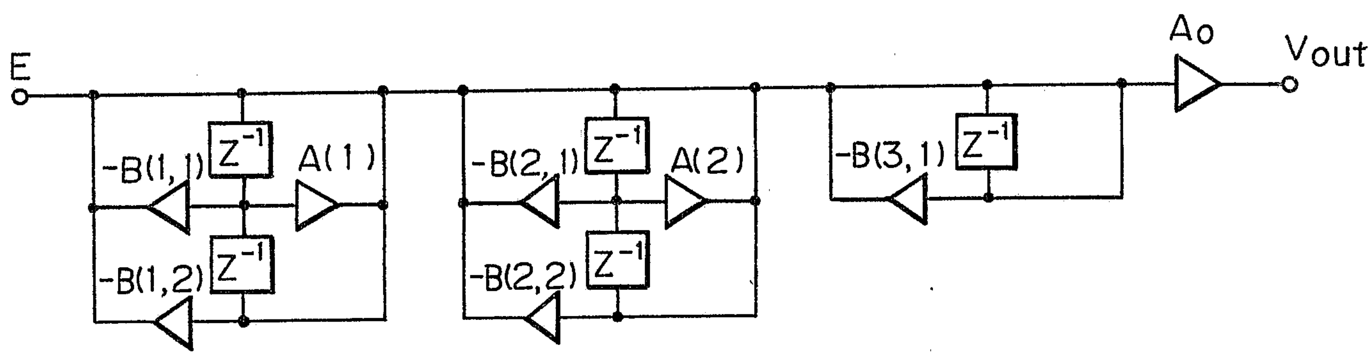


MULTIPLIER$_1$: A(1)=-1.3390091
MULTIPLIER$_2$: A(2)=-0.82228309
MULTIPLIER$_0$: $A_0$ = 0.016677094
DELAY ELEMENT: $Z^{-1}$

MULTIPLIER$_{11}$: B(1,1)=-1.5246771
MULTIPLIER$_{12}$: B(1,2)=0.91004454
MULTIPLIER$_{21}$: B(2,1)=-1.4460079
MULTIPLIER$_{22}$: B(2,2)=0.67160943
MULTIPLIER$_{31}$: B(3,1)=-0.70134506

Fig. 40

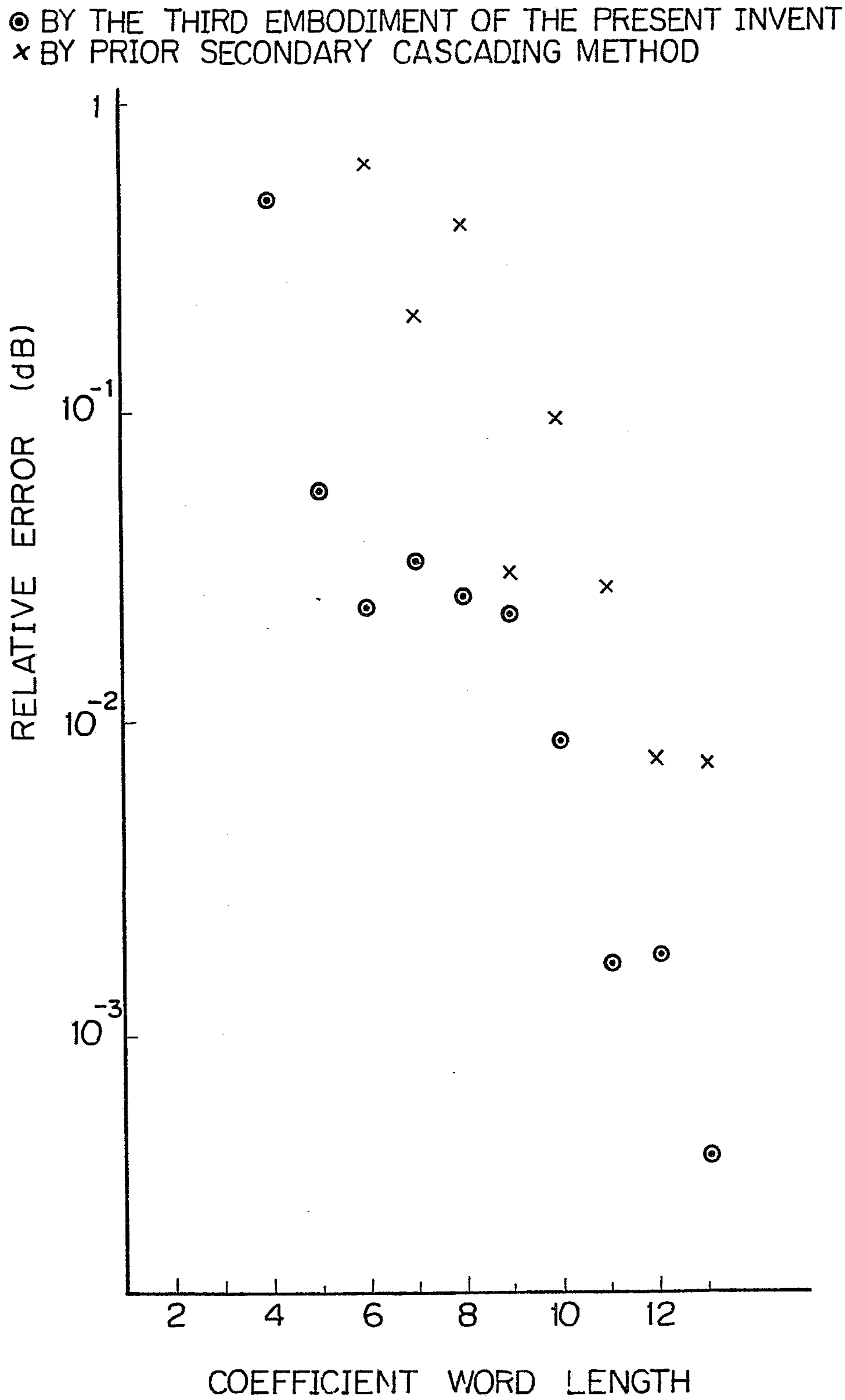
⊙ BY THE THIRD EMBODIMENT OF THE PRESENT INVENTION
× BY PRIOR SECONDARY CASCADING METHOD
RELATIVE ERROR (dB)
1
$10^{-1}$
$10^{-2}$
$10^{-3}$
2
4
6
8
10
12
COEFFICIENT WORD LENGTH

0194318

# INTERNATIONAL SEARCH REPORT

International Application No PCT/JP85/00489

**I. CLASSIFICATION OF SUBJECT MATTER** (if several classification symbols apply, indicate all) [3]

According to International Patent Classification (IPC) or to both National Classification and IPC

Int.Cl[4] H03H17/04

**II. FIELDS SEARCHED**

Minimum Documentation Searched [4]

| Classification System | Classification Symbols |
|---|---|
| IPC | H03H17/00 - 17/08 |

Documentation Searched other than Minimum Documentation to the Extent that such Documents are Included in the Fields Searched [5]

**III DOCUMENTS CONSIDERED TO BE RELEVANT** [14]

| Category* | Citation of Document, with indication, where appropriate, of the relevant passages | Relevant to Claim No [18] |
|---|---|---|
| A | PROCEEDINGS OF THE IEEE, VOL. 55, NO. 2, FEBRUARY, 1967, PP149-171 [Digital Filter Design Techniques in the Frequency Donain] | 1 - 12 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search [2] | Date of Mailing of this International Search Report [2] |
|---|---|
| November 14, 1985 (14.11.85) | December 2, 1985 (02.12.85) |
| International Searching Authority [1] | Signature of Authorized Officer [20] |
| Japanese Patent Office | |